# EUROPÄISCHE PATENTSCHRIFT

(11) **EP 0 911 981 B1**
(45) Veröffentlichungstag und Bekanntmachung des Hinweises auf die Patenterteilung: **21.07.2004**
(21) Anmeldenummer: 98119235.4
(22) Anmeldetag: 12.10.1998
(51) Int. Cl.: H03M 7/40

(54) **Verfahren und Vorrichtung zum Codieren bzw. Decodieren eines Audiosignals**
Method and device for coding/decoding an audio signal
Méthode et dispositif de codage/ décodage d'un signal audio

(30) Priorität: 24.10.1997 DE 19747119; 07.09.1998 DE 19840853
(43) Veröffentlichungstag der Anmeldung: 28.04.1999
(73) Patentinhaber: Fraunhofer-Gesellschaft zur Förderung der angewandten Forschung e.V., 80686 München (DE)
(72) Erfinder: Sperschneider, Ralph, 91056 Erlangen (DE); Dietz, Martin, 90408 Nürnberg (DE); Ehret, Andreas, 90429 Nüurnberg (DE); Brandenburg, Karlheinz, Dr., 91054 Erlangen (DE); Gerhäuser, Heinz, Dr., 91344 Waischenfeld (DE); Ali Nowbakht-Irani, 5611 WE Eindhoven (NL); Pierre Lauber, 90419 Nürnberg (DE); Roland Bitto, 90453 Nürnberg (DE)
(74) Vertreter: Schoppe, Fritz, Dipl.-Ing.

(56) Entgegenhaltungen:
- EP-A- 0 492 537
- EP-A- 0 717 503
- SHAW-MIN LEI: "THE CONSTRUCTION OF EFFICIENT VARIABLE-LENGTH CODES WITH CLEAR SYNCHRONIZING CODEWORDS FOR DIGITAL VIDEO APPLICATIONS" VISUAL COMMUNICATION AND IMAGE PROCESSING '91: VISUAL COMMUNICATION, BOSTON, NOV. 11 - 13, 1991, Bd. PART 2, Nr. VOL. 1605, 11. November 1991 (1991-11-11), Seiten 863-873, XP000479292 KOU-HU TZOU;TOSHIO KOGA

## Beschreibung

Die vorliegende Erfindung bezieht sich auf Verfahren und Vorrichtungen zum Codieren bzw. Decodieren eines Audiosignals bzw. eines Bitstroms, die eine fehlerrobuste Entropiecodierung bzw. -decodierung und insbesondere eine fehlerrobuste Huffman-Codierung bzw. -decodierung ausführen können.

Moderne Audiocodierverfahren bzw. -decodierverfahren, die beispielsweise nach dem Standard MPEG-Layer 3 arbeiten, sind in der Lage, die Datenrate von Audiosignalen beispielsweise um einen Faktor 12 zu komprimieren, ohne die Qualität derselben merkbar zu verschlechtern. Um eine derartig hohe Datenratenreduktion zu erreichen, wird ein Audiosignal abgetastet, wodurch eine Folge von zeitdiskreten Abtastwerten erhalten wird. Wie es in der Technik bekannt ist, wird diese Folge von zeitdiskreten Abtastwerten mittels geeigneter Fensterfunktionen gefenstert, um gefensterte Blöcke von zeitlichen Abtastwerten zu erhalten. Ein Block zeitlich gefensterter Abtastwerte wird dann mittels einer Filterbank, einer modifizierten diskreten Cosinustransformation (MDCT) oder einer anderen geeigneten Einrichtung in den Frequenzbereich transformiert, um Spektralwerte zu erhalten, die insgesamt das Audiosignal, d. h. den zeitlichen Ausschnitt, der durch den Block von zeitdiskreten Abtastwerten gegeben ist, im Frequenzbereich darstellen. Üblicherweise werden sich zu 50% überlappende zeitliche Blöcke erzeugt und mittels einer MDCT in den Frequenzbereich transformiert, wodurch aufgrund der speziellen Eigenschaften der MDCT immer beispielsweise 1024 zeitdiskrete Abtastwerte zu 1024 Spektralwerten führen.

Es ist bekannt, daß die Aufnahmefähigkeit des menschlichen Ohrs vom Augenblicksspektrum des Audiosignals selbst abhängt. Diese Abhängigkeit ist in dem sog. psychoakustischen Modell erfaßt, mittels dem es seit längerem möglich ist, abhängig vom augenblicklichen Spektrum Maskierungsschwellen zu berechnen. Maskierung bedeutet, daß ein bestimmter Ton bzw. Spektralanteil verdeckt wird, wenn beispielsweise ein benachbarter Spektralbereich eine relativ hohe Energie besitzt. Diese Tatsache der Maskierung wird ausgenutzt, um die nach der Transformation vorhandenen Spektralwerte möglichst grob zu quantisieren. Es wird daher angestrebt, einerseits hörbare Störungen im wieder decodierten Audiosignal zu vermeiden und andererseits möglichst wenig Bits zu verwenden, um das Audiosignal zu codieren bzw. hier zu quantisieren. Die durch die Quantisierung eingeführten Störungen, d. h. das Quantisierungsrauschen, soll unter der Maskierungsschwelle liegen und somit unhörbar sein. Gemäß bekannter Verfahren wird daher eine Einteilung der Spektralwerte in sog. Skalenfaktorbänder durchgeführt, die den Frequenzgruppen des menschlichen Ohrs entsprechen sollten. Spektralwerte in einer Skalenfaktorgruppe werden mit einem Skalenfaktor multipliziert, um Spektralwerte eines Skalenfaktorbandes insgesamt zu skalieren. Die durch den Skalenfaktor skalierten Skalenfaktorbänder werden anschließend quantisiert, woraufhin quantisierte Spektralwerte entstehen. Selbstverständlich ist eine Gruppierung in Skalenfaktorbänder nicht entscheidend. Sie wird jedoch bei den Standards MPEG-Layer 3 bzw. bei dem Standard MPEG-2 AAC (AAC = Advanced Audio Coding) verwendet.

Ein sehr wesentlicher Aspekt der Datenreduzierung besteht in der nach dem Quantisieren folgenden Entropie-Codierung der quantisierten Spektralwerte. Für die Entropiecodierung wird üblicherweise eine Huffman-Codierung verwendet. Unter einer Huffman-Codierung versteht man eine Codierung mit variabler Länge, d. h. die Länge des Codeworts für einen zu codierenden Wert ist abhängig von dessen Auftrittswahrscheinlichkeit. Logischerweise ordnet man dem wahrscheinlichsten Zeichen den kürzesten Code, d. h. das kürzeste Codewort, zu, so daß mit der Huffman-Codierung eine sehr gute Redundanzreduktion erreicht werden kann. Ein Beispiel für eine allseits bekannte Codierung mit variabler Länge ist das Morse-Alphabet.

In der Audiocodierung werden Huffman-Codes zur Codierung der quantisierten Spektralwerte benutzt. Ein moderner Audio-Coder, der beispielsweise nach dem Standard MPEG-2 AAC arbeitet, verwendet zur Codierung der quantisierten Spektralwerte verschiedene Huffman-Codetabellen, die dem Spektrum nach bestimmten Kriterien abschnittsweise zugeordnet werden. Dabei werden immer 2 oder 4 Spektralwerte in einem Codewort gemeinsam codiert.

Ein Unterschied des Verfahrens nach MPEG-2 AAC gegenüber dem Verfahren MPEG-Layer 3 besteht nun darin, daß verschiedene Skalenfaktorbänder, d. h. verschiedene Spektralwerte, zu beliebig vielen Spektralabschnitten oder "Sections" gruppiert werden. Bei AAC umfaßt ein Spektralabschnitt oder eine "Section" zumindest vier Spektralwerte aber vorzugsweise mehr als vier Spektralwerte. Der gesamte Frequenzbereich der Spektralwerte wird daher in benachbarte Sections aufgeteilt, wobei eine Section ein Frequenzband darstellt, derart, daß alle Sections zusammen den gesamten Frequenzbereich, der durch die Spektralwerte nach der Transformation derselben überdeckt wird, umfassen.

Einem Abschnitt wird nun ebenso wie beim MPEG-Layer-3-Verfahren zum Erreichen einer maximalen Redundanzreduktion eine sog. Huffman Tabelle aus einer Mehrzahl derartiger Tabellen zugeordnet. Im Bitstrom des AAC-Verfahrens, welches üblicherweise 1024 Spektralwerte aufweist, befinden sich nun die Huffman-Codewörter für die Spektralwerte in aufsteigender Frequenzreihenfolge. Die Information über die in jedem Frequenzabschnitt verwendete Tabelle wird in den Seiteninformationen übertragen. Diese Situation ist in Fig. 2 dargestellt.

Fig. 2 stellt den beispielhaften Fall dar, bei dem der Bitstrom 10 Huffman-Codewörter umfaßt. Wenn immer aus einem Spektralwert ein Codewort gebildet wird, so können hier 10 Spektralwerte codiert sein. Üblicherweise werden jedoch immer 2 oder 4 Spektralwerte durch ein Codewort gemeinsam codiert, weshalb Fig. 2 einen Teil des codierten Bitstroms darstellt, der 20 bzw. 40 Spektralwerte umfaßt. In dem Fall, in dem jedes Huffman-Codewort 2 Spektralwerte umfaßt, stellt das mit der Nr. 1 bezeichnete Codewort die ersten 2 Spektralwerte dar, wobei die Länge des Codeworts Nr. 1 relativ klein ist, was bedeutet, daß die Werte der beiden ersten Spektralwerte, d. h. der beiden niedrigsten Frequenzkoeffizienten, relativ häufig auftreten. Das Codewort mit der Nr. 2 hingegen besitzt eine relativ große Länge, was bedeutet, daß die Beträge des 3. und 4. Spektralkoeffizienten im codierten Audiosignal relativ selten sind, weshalb dieselben mit einer relativ großen Bitmenge codiert werden. Aus Fig. 2 ist ferner ersichtlich, daß die Codewörter mit den Nr. 3, 4 und 5, die die Spektralkoeffizienten 5 und 6, bzw. 7 und 8 bzw. 9 und 10 darstellen, ebenfalls relativ häufig auftreten, da die Länge der einzelnen Codewörter relativ gering ist. Ähnliches gilt für die Codewörter mit den Nr. 6 - 10.

Wie es bereits erwähnt wurde, ist es aus Fig. 2 deutlich ersichtlich, daß die Huffman-Codewörter für die codierten Spektralwerte bezüglich der Frequenz linear ansteigend im Bitstrom angeordnet sind, wenn ein Bitstrom betrachtet wird, der durch eine bekannte Codiervorrichtung erzeugt wird.

Ein großer Nachteil von Huffman-Codes im Falle fehlerbehafteter Kanäle ist die Fehlerfortplanzung. Es sei beispielsweise angenommen, daß das Codewort Nr. 2 in Fig. 2 gestört ist. Mit einer gewissen nicht niedrigen Wahrscheinlichkeit ist dann auch die Länge dieses falschen Codeworts Nr. 2 verändert. Dieselbe unterscheidet sich somit von der richtigen Länge. Wenn im Beispiel von Fig. 2 das Codewort Nr. 2 bezüglich seiner Länge durch eine Störung verändert worden ist, ist es für einen Codierer nicht mehr möglich, die Anfänge der Codewörter 3 - 10, d. h. fast des gesamten dargestellten Audiosignals, zu bestimmen. Es können also auch alle anderen Codewörter nach dem gestörten Codewort nicht mehr richtig decodiert werden, da nicht bekannt ist, wo diese Codewörter beginnen, und da ein falscher Startpunkt aufgrund des Fehlers gewählt wurde.

Das europäische Patent Nr. 0612156 schlägt als Lösung für das Problem der Fehlerfortpflanzung vor, einen Teil der Codewörter variabler Länge in einem Raster anzuordnen, und die restlichen Codewörter in die verbleibenden Lücken zu verteilen, so daß ohne vollständige Decodierung oder bei fehlerhafter Übertragung der Anfang eines Codeworts leichter gefunden werden kann.

Das bekannte Verfahren schafft für die Fehlerfortpflanzung eine teilweise Abhilfe durch Umsortierung der Codewörter. Für manche Codewörter wird ein fester Platz im Bitstrom vereinbart, während für die restlichen Codewörter die verbleibenden Zwischenräume zur Verfügung stehen. Dies kostet keine zusätzlichen Bits, verhindert aber im Fehlerfall die Fehlerfortpflanzung unter den umsortierten Codewörtern.

Entscheidender Parameter für die Effizienz des bekannten Verfahrens ist jedoch, wie das Raster in der praktischen Anwendung bestimmt wird, d. h. wie viele Rasterpunkte verwendet werden müssen, welchen Rasterabstand die Rasterpunkte haben, usw. Das europäische Patent 0612156 liefert jedoch neben dem allgemeinen Hinweis, ein Raster zur Eindämmung der Fehlerfortpflanzung zu verwenden, keine näheren Hinweise darauf, wie das Raster effizient gestaltet werden soll, um einerseits eine fehlerrobuste Codierung und andererseits auch eine effiziente Codierung zu ermöglichen.

Die EP-A-0 717 503 offenbart ein digitales Codier- und Decodierverfahren, bei dem zeitdiskrete Abtastwerte eines Musiksignals in den Frequenzbereich transformiert werden, woraufhin die erhaltenen Spektralwerte quantisiert und dann Entropie-codiert werden. Die Entropie-Codierung liefert eine bestimmte Anzahl von Codewörtern variabler Länge, wobei ein Teil der Codewörter in einem Raster angeordnet wird, während die restlichen Codewörter in verbleibende Lücken des Rasters eingebracht werden.

Die EP-A-0 492 537 bezieht sich auf eine Informationsaufzeichnungsvorrichtung für Video- und Audioinformationen, bei der Informationen in kleine Blöcke von Pixeln aufgeteilt werden, von denen jeder eine Mehrzahl von Pixeln umfaßt, woraufhin jeder kleine Block in orthogonale Komponenten mittels eine Orthogonaltransformation überführt wird. Die orthogonalen Komponenten werden hierauf unter Verwendung eines Codes mit Codewörtern variabler Länge codiert. Ein Teil der codierten Codewörter wird in einen ersten Speicher geschrieben, wobei, wenn ein Codewort mehr Bits hat als für den ersten Speicher vorgesehen, die restlichen Bits dieses Codeworts in einen anderen Speicher geschrieben werden.

Die Aufgabe der vorliegenden Erfindung besteht darin, ein Konzept zum fehlerrobusten und dennoch effizienten Codieren und Decodieren eines Audiosignals bzw. eines Bitstroms zu schaffen.

Diese Aufgabe wird durch ein Verfahren zum Codieren eines Audiosignals gemäß Anspruch 1 oder 9, durch eine Vorrichtung zum Codieren eines Audiosignals gemäß Anspruch 21 oder 22, durch ein Verfahren zum Decodieren eines Bitstroms gemäß Anspruch 23 oder 24 und durch eine Vorrichtung zum Decodieren eines Bitstroms gemäß Anspruch 25 oder 26 gelöst.

Der vorliegenden Erfindung liegt die Erkenntnis zugrunde, daß das bereits vorgeschlagene Raster in bestimmter Weise ausgestaltet bzw. belegt werden muß, um neben einer fehlerrobusten Codierung bzw. Decodierung auch eine effiziente Codierung bzw. Decodierung zu erreichen. Wesentlich dabei ist, daß die Codewörter, die durch eine Entropiecodierung in Form einer Huffman-Codierung erhalten werden, inhärent eine unterschiedliche Länge haben, da der größte Codierungsgewinn erreicht wird, wenn einem zu codierenden Wert, der am häufigsten auftritt, ein möglichst kurzes Codewort zugewiesen wird. Dagegen führt ein zu codierender Wert, der relativ selten auftritt, trotz eines relativ langen Codeworts, das demselben zugewiesen wird, zu einer statistisch gesehen optimalen Datenmenge. Codewörter, die durch eine Huffman-Codierung erhalten werden, weisen also an sich unterschiedliche Längen auf.

Gemäß einem ersten Aspekt der vorliegenden Erfindung werden an den Rasterpunkten sog. Prioritätscodewörter plaziert, derart, daß trotz eines möglichen Fehlers im Bitstrom aufgrund des Rasters immer der Anfang der Prioritätscodewörter von einem Decodierer sicher festgestellt werden kann. Unter Prioritätscodewörtern sind Codewörter zu verstehen, die psychoakustisch bedeutsam sind. Dies bedeutet, daß die Spektralwerte, die durch sog. Prioritätscodewörter codiert sind, wesentlich zum Höreindruck eines decodierten Audiosignals beitragen. Wenn das Audiosignal beispielsweise einen großen Anteil an Sprache aufweist, so könnten die Prioritätscodewörter die Codewörter sein, die eher niedrigere Spektralwerte darstellen, da die wesentlichen Spektralinformationen in diesem Falle im niedrigen Spektralbereich auftreten. Wenn an ein Audiosignal gedacht wird, das eine Gruppe von Tönen im mittleren Frequenzbereich aufweist, so könnten die Prioritätscodewörter die Codewörter sein, die den Spektralwerten in dem entsprechenden mittleren Frequenzbereich zugeordnet sind, da dieselben dann die psychoakustisch bedeutsamen Spektralwerte sind. Psychoakustisch bedeutsame Spektralwerte könnten auch Spektralwerte sein, die im Vergleich zu anderen Spektralwerten im Spektrum einen großen Betrag, d. h. eine große Signalenergie, umfassen. Psychoakustisch weniger bedeutsame Codewörter, die auch als Nicht-Prioritätscodewörter bezeichnet werden, füllen dagegen das Raster auf. Sie werden also nicht mit Rasterpunkten ausgerichtet, sondern in den noch freien Plätzen nach dem Positionieren der Prioritätscodewörter auf die Rasterpunkte "einsortiert".

Gemäß dem ersten Aspekt der vorliegenden Erfindung werden somit die Prioritätscodewörter, die Spektralwerten zugeordnet sind, welche psychoakustisch bedeutsam sind, in einem Raster derart angeordnet, daß der Anfang der Prioritätscodewörter mit den Rasterpunkten zusammenfällt.

Gemäß einem zweiten Aspekt der vorliegenden Erfindung wird eine Gruppierung der Spektralwerte in Spektralabschnitte durchgeführt, wobei jedem Spektralabschnitt eine andere Codetabelle zugeordnet wird. Die Zuordnung einer Codetabelle zu einem Spektralabschnitt beruht auf signalstatistischen Aspekten, d. h. welche Codetabelle optimal zur Codierung eines Spektralabschnitts geeignet ist, wobei die Zuordnung einer Codetabelle zu einem Spektralabschnitt in der Technik bereits bekannt ist.

Es wird nun ein Raster verwendet, welches mehrere Gruppen von in sich äquidistanten Rasterpunkten aufweist, derart, daß der Abstand der Rasterpunkte einer Gruppe von Rasterpunkten von der Codetabelle abhängt, die zur Codierung eines Spektralabschnitts verwendet wird. In einem anderen Spektralabschnitt wird eine andere Codetabelle verwendet, um eine optimale Datenreduktion zu erreichen. Der anderen Codetabelle ist wiederum eine andere äquidistante Gruppe von Rasterpunkten zugeordnet, wobei der Abstand zwischen zwei Rasterpunkten dieser anderen Gruppen von Rasterpunkten von der entsprechenden weiteren Codetabelle abhängt. Die Abhängigkeit des Abstands zweier Rasterpunkte in den verschiedenen Gruppen von Rasterpunkten kann zumindest auf drei verschiedene Arten und Weisen bestimmt werden.

Zum einen wird die maximale Länge eines Codeworts einer Codetabelle ermittelt. Der Abstand zweier Rasterpunkte in der Rasterpunktgruppe, die dieser Codetabelle zugeordnet ist, kann nun gleich oder größer als die maximale Codewortlänge in der Codetabelle gewählt werden, derart, daß auch das längste Codewort dieser Codetabelle in dem Raster Platz hat. Analog dazu wird der Abstand zweier Rasterpunkte einer anderen Gruppe von Rasterpunkten, die wiederum einer anderen Codetabelle entspricht, gemäß der maximalen Codewortlänge dieser anderen Codetabelle bestimmt.

Die zweite Alternative, die nachfolgend beschrieben ist, kann ebenfalls zu einer Erhöhung der Anzahl der Rasterpunkte beitragen. Aufgrund der inhärenten Eigenschaften des Huffman-Codes sind seltener auftretende Codewörter eher länger als häufiger auftretende Codewörter. Wenn daher der Rasterpunktabstand gleich oder größer als die Länge des Codeworts mit maximaler Länge einer Tabelle gewählt wird, so werden meistens Codewörter ins Raster eingefügt, die kürzer als der Rasterpunktabstand sind. Der Rasterpunktabstand kann daher auch kleiner als die Länge des längsten Codeworts einer Tabelle gewählt werden. Falls dann beim Codieren ein Codewort auftritt, das nicht ins Raster paßt, so wird der nicht ins Raster passende Rest an einer anderen geeigneten Stelle nicht mit dem Raster ausgerichtet in den Bitstrom eingetragen. Dies führt dazu, daß dieses "zerstückelte" Codewort nicht mehr wirksam vor einer Fehlerfortpflanzung geschützt ist. Da dasselbe jedoch sehr selten auftritt, kann dies im Interesse einer Erhöhung der Anzahl der Rasterpunkte in Kauf genommen werden.

Die dritte Möglichkeit zum Bestimmen der unterschiedlichen Rasterpunktabstände besteht darin, nicht die maximale Codewortlänge einer Tabelle zu berücksichtigen, sondern die Länge des längsten tatsächlich auftretenden Codeworts im Bitstrom in einem codierten Spektralabschnitt zu verwenden.

Gemäß einem dritten Aspekt der vorliegenden Erfindung kann anstelle einer im wesentlichen linear mit der Frequenz ansteigenden Anordnung der Codewörter im Bitstrom ein frequenzmäßig verteiltes Anordnen der Codewörter verwendet werden, wobei dieses Verfahren auch als "Scramblen" bezeichnet wird. Dies hat den Vorteil, daß sog. "Burst"-Fehler nicht zu einer fehlerhaften Decodierung eines kompletten Frequenzbandes führt, sondern nur kleine Störungen in mehreren verschiedenen Frequenzbereichen erzeugen.

Gemäß einem vierten Aspekt der vorliegenden Erfindung kann ferner anstelle einer linear mit der Frequenz ansteigenden Anordnung der Codewörter auch eine Anordnung verwendet werden, bei der z. B. nur jedes n-te Codewort (z. B. jedes 2. oder jedes 3. oder jedes 4., ...) im Raster angeordnet wird. Dadurch wird es möglich, durch Prioritätscodewörter einen möglichst großen Spektralbereich zu überdecken, d. h. gegen eine Fehlerfortpflanzung zu schützen, wenn die Anzahl der möglichen Rasterpunkte kleiner als die Anzahl der Prioritätscodewörter ist.

Ferner wird es bevorzugt, daß die Prioritätscodewörter auf eine bestimmte Art und Weise bestimmt werden, damit ein effizienter Betrieb erreicht wird. Daher wird bevorzugterweise von der Annahme Abschied genommen, daß die psychoakustisch bedeutsamen Codewörter, d. h. Prioritätscodewörter, die sind, die Spektralwerte mit niedriger Frequenz codieren. Dies wird sehr oft zutreffen, muß jedoch nicht immer der Fall sein.

Normalerweise sind Prioritätscodewörter, Codewörter, die psychoakustisch bedeutsame Spektrallinien codieren, welche üblicherweise Spektralwerte mit hoher Energie sind. Genauso wichtig ist es, daß Spektrallinien mit hoher Energie nicht aufgrund von Fehlern auftreten.

Erfindungsgemäß wird ein Indikator verwendet, der bereits implizit gegeben ist. Der Indikator hängt von der verwendeten Codetabelle ab. Beim AAC-Standard existieren beispielsweise elf Codetabellen, die voneinander unterschiedliche absolute Wertebereiche haben. Die Codetabelle Nr. 1 umfaßt z. B. Spektralwerte mit einem Absolutwert von -1 bis +1, während die Codetabelle Nr. 11 Spektralwerte von -8191 bis +8191 codieren kann. Je höher die Codetabelle ist, umso größer ist auch der durch dieselbe erlaubte Wertebereich. Dies bedeutet, daß Codetabellen mit niedrigen Nummern nur relativ kleine Werte darstellen und daher nur relativ kleine Fehler erlauben, während Codetabellen mit höheren Nummern relativ große Werte darstellen können und daher ebenfalls relativ große Fehler.

Tritt in einer niedrigen Codetabelle ein Fehler auf, so wird derselbe unter Umständen gar nicht hörbar sein, da eine fehlerhafte Spektrallinie entsteht, die sich absolut gesehen nicht so stark von der ursprünglich korrekten Spektrallinie unterscheidet. Tritt jedoch in der höchsten Codetabelle ein Fehler auf, so kann dieser Fehler prinzipiell alle möglichen Absolutwerte in dieser Codetabelle annehmen. Wenn eine mit der höchsten Codetabelle codierte Spektrallinie beispielsweise einen geringen Wert hatte und durch einen Fehler während der Übertragung im Decodierer als Spektrallinie decodiert wird, die den höchsten absoluten Wert dieser Codetabelle hat, so wird diese fehlerhafte Spektrallinie sicherlich hörbar sein.

Bezüglich Fehlerrobustheit ist die wichtigste Codetabelle daher die höchste Codetabelle (beim AAC-Standard die Codetabelle Nr. 11), da diese Codetabelle Escape-Werte mit einem Bereich zwischen -2¹³ + 1 (-8191) und +2¹³ - 1 (+8191) zuläßt.

Gemäß einem weiteren Aspekt der vorliegenden Erfindung werden beim AAC-Standard kurze Fenster bei transienten Signalen verwendet. Bei kurzen Fenstern wird die Frequenzauflösung zugunsten einer höheren zeitlichen Auflösung verringert. Eine Bestimmung der Prioritätscodewörter wird dahingehend durchgeführt, daß mit Sicherheit psychoakustisch bedeutsame Spektralwerte, d. h. Spektralwerte bei niedrigeren Frequenzen oder Spektralwerte aus höheren Codetabellen, auf Rasterpunkte plaziert werden. Eine z. B. beim AAC-Standard durchgeführte skalenfaktorbandweise Verschachtelung wird dafür aufgehoben.

Bevorzugte Ausführungsbeispiele der vorliegenden Erfindung werden nachfolgend bezugnehmend auf die beiliegenden Zeichnungen detaillierter erörtert. Es zeigen:
- Fig. 1: ein Beispiel für eine erfindungsgemäße Rasterung eines codierten Bitstroms, der Codewörter enthält, anhand des zweiten Aspekts der vorliegenden Erfindung; und
- Fig. 2: eine linear mit der Frequenz ansteigende Anordnung von Codewörtern gemäß dem Stand der Technik.

Zur Erläuterung der vorliegenden Erfindung sind in Fig. 2, die eine bekannte linear mit der Frequenz ansteigende Anordnung von Codewörtern unterschiedlicher Länge darstellt, Prioritätscodewörter schraffiert dargestellt. In Fig. 2 sind Prioritätscodewörter die Codewörter Nr. 1 - Nr. 5. Wie es bereits oben erwähnt wurde, sind die Codewörter, welche frequenzmäßig niedrigen Spektralwerten zugeordnet sind, dann Prioritätscodewörter, wenn das Audiosignal beispielsweise einen hohen Sprachanteil enthält, oder relativ viele Töne, welche niederfrequent sind. Die Codewörter Nr. 6 - 10 in Fig. 2 beziehen sich auf höherfrequentere Spektralwerte, welche zwar zum Gesamteindruck des decodierten Audiosignals sehr wohl beitragen, welche jedoch keine wesentlichen Auswirkungen auf den Höreindruck haben und somit psychoakustisch weniger bedeutsam sind.

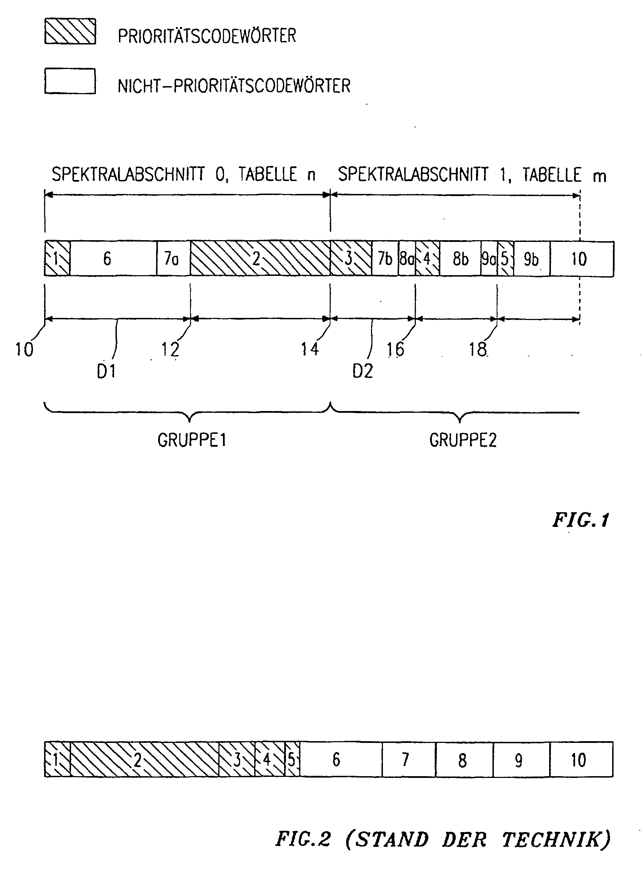

Fig. 1 zeigt nun einen Bitstrom, der eine Anzahl von Rasterpunkten 10 - 18 aufweist, wobei der Abstand zwischen dem Rasterpunkt 10 und dem Rasterpunkt 12 als D1 bezeichnet ist, während der Abstand zwischen dem Rasterpunkt 14 und dem Rasterpunkt 16 als D2 bezeichnet wird.

Bezüglich der Darstellung des ersten Aspekts der vorliegenden Erfindung sei lediglich der Teil des Bitstroms betrachtet, der sich vom Rasterpunkt 10 bis zum Rasterpunkt 14 erstreckt. Die Prioritätscodewörter 1 und 2 werden nun im Raster ausgerichtet, damit sichergestellt ist, daß die wesentlichen Spektralanteile, die sich bei dem in Fig. 2 dargestellten Beispielsignal im unteren Frequenzbereich befinden, bei einer Codierung keiner Fehlerfortpflanzung unterworfen werden. Nicht-Prioritätscodewörter, welche in den Fig. nicht schraffiert sind, werden nach den Prioritätscodewörtern angeordnet, um das Raster auszufüllen. Es ist nicht erforderlich, daß die Nicht-Prioritätscodewörter am Stück in das Raster passen, da sich die Länge eines Huffman-Codeworts aus sich selbst ergibt. Ein Decodierer weiß also, ob er nur den Teil eines Codeworts eingelesen hat. In diesem Falle wird er automatisch eine bestimmte Anzahl von Bits nach dem Prioritätscodewort hinter dem nächsten Rasterpunkt dem ersten Codewortstück hinzufügen. Es ist somit möglich, einen ersten Teil eines Nicht-Prioritätscodeworts in einer ersten noch freien Position im Raster einzufügen, und den restlichen Teil desselben an einer anderen Stelle, wie es beispielsweise durch die Nicht-Prioritätscodewörter 7, 8 und 9 dargestellt ist, welche im Bitstrom jeweils zweigeteilt worden sind, d. h. 7a, 7b bzw. 8a, 8b bzw. 9a, 9b.

Wie bereits dargestellt wurde, bezieht sich der 2. Teil des Bitstroms von Fig. 1 bereits auf den zweiten Aspekt der vorliegenden Erfindung. Würde der Rasterabstand D1 nicht zu einem kleineren Rasterabstand D2 verändert werden, so würde ein Raster mit dem Abstand D1, in dem alle Prioritätscodewörter 1 bis 5 angeordnet werden sollen, zu einem derart langen Bitstrom führen, daß sozusagen nicht genug Nicht-Prioritätscodewörter vorhanden sind, um alle im Raster verbleibenden Lücken aufzufüllen. Es werden daher aus einem Audiosignal nur so viel Prioritätscodewörter extrahiert, wie im Bitstrom eingesetzt werden können, damit im wesentlichen keine freien Stellen zurückbleiben, d. h. damit der Bitstrom nicht unnötig verlängert wird.

Anschließend wird bezugnehmend auf Fig. 1 auf den zweiten Aspekt der vorliegenden Erfindung detailliert eingegangen. Im Falle des Codierverfahrens nach dem Standard MPEG-2 AAC können 11 verschiedene Huffman-Codetabellen zur Codierung verwendet werden. Für die meisten dieser Tabellen beträgt die maximal mögliche Codewortlänge zwischen 10 und 20 Bit. Eine spezielle Tabelle, die sog. "Escape"-Tabelle, umfaßt jedoch eine Länge von maximal 49 Bit. Würde man hier als Rasterabstand D die Länge des längsten Codeworts aller Tabellen verwenden, so erhielte man einen Rasterabstand von 49 Bit, was zu einem Raster mit sehr großer Breite führt und daher für fast alle Tabellen ineffizient ist, da der Bitstrom viel zu lang werden würde, wenn alle Prioritätscodewörter mit einem Rasterpunkt ausgerichtet werden sollen. Erfindungsgemäß wird daher die Breite des Rasters in Abhängigkeit der benutzten Codetabelle eingestellt. Wie bereits eingangs erwähnt wurde, können Spektralwerte in Spektralabschnitte gruppiert werden, wobei dann unter Berücksichtigung signalstatistischer Aspekte jedem Spektralabschnitt eine für denselben optimale Codetabelle zugeordnet wird. Die maximale Codewortlänge in einer Codetabelle unterscheidet sich jedoch zumeist von der maximalen Codewortlänge einer anderen Tabelle.

So sei angenommen, daß die Spektralwerte, die durch die Codewörter 1 und 2 dargestellt werden, zu einem ersten Spektralabschnitt gehören, während die Spektralwerte, die durch die Codewörter 3 - 10 dargestellt sind, zu einem zweiten Spektralabschnitt gehören. Der Bitstrom wird nun gerastert, indem 2 Gruppen von Rasterpunkten verwendet werden, wobei die 1. Gruppe von Rasterpunkten die Rasterpunkte 10, 12 und 14 aufweist, während die 2. Gruppe von Rasterpunkten die Rasterpunkte 14, 16 und 18 aufweist. Ferner sei angenommen, daß dem Spektralabschnitt 0 die Huffman-Codetabelle n zugewiesen wurde, während dem Spektralabschnitt 1 die Huffman-Codetabelle m zugeordnet wurde. Außerdem sei angenommen, daß das Codewort 2 das längste Codewort der Tabelle n ist, die dem Spektralabschnitt 0 zugeordnet wurde. Der Rasterabstand der 1. Gruppe von Rasterpunkten wird größer oder vorzugsweise gleich der maximalen Länge des Codeworts der Tabelle n, im Beispiel also des Codeworts Nr. 2, eingestellt.

Der Abschnitt des Bitstroms zwischen dem Rasterpunkt 14 und dem Ende des Bitstroms am Codewort Nr. 10 zeigt dagegen, daß in diesem gewählten Beispiel das Codewort mit der maximalen Länge der Codetabelle m im Bitstrom nicht auftritt. In dem Bitstromraster, das durch die Gruppe 2 bezeichnet ist, existiert also kein Codewort, das eine Länge D2 aufweist.

Gemäß dem zweiten Aspekt der vorliegenden Erfindung wird die Breite des Rasters also abhängig von der benutzten Codetabelle eingestellt. Es sei darauf hingewiesen, daß in diesem Fall jedoch die verwendete Tabelle im Decodierer zur Decodierung bereits bekannt sein muß. Dies ist jedoch der Fall, da als Seiteninformationen ohnehin für jeden Spektralabschnitt eine Codetabellennummer übertragen wird, mittels der ein Decodierer die verwendete Codetabelle aus einem vorgegebenen Satz von in diesem Beispiel 11 verschiedenen Huffman-Tabellen identifizieren kann.

Wie es bereits angesprochen wurde, ist bei einer Abhängigkeit des Rasterabstands von der verwendeten Codetabelle besonders wenn an die Escape-Tabelle, deren Länge 49 Bit beträgt, gedacht wird, noch immer keine optimale Datenreduktion zu erreichen, da im Falle einer Escape-Tabelle die Rasterbreite auf 49 Bit eingestellt wird, um maximal große Spektralwerte zu codieren. Escape-Tabellen werden eingesetzt, um zum einen relativ kurze Codetabellen zu haben, um jedoch zum anderen relativ große Werte mittels der kurzen Codetabellen in Verbindung mit einer Escape-Tabelle codieren zu können. Im Falle eines Werts, der den Wertebereich einer Codetabelle übersteigt, nimmt das Codewort für diesen Spektralwert einen vorbestimmten Wert an, der dem Decodierer signalisiert, daß zusätzlich eine Escape-Tabelle im Codierer verwendet worden ist. Umfaßt eine Codetabelle beispielsweise die Werte von 0 - 2, so würde ein Wert von 3 in der Codetabelle dem Decodierer signalisieren, daß auf eine Escape-Tabelle zurückgegriffen wird. Dem Codewort mit dem Wert 3 der "Grund"-Codetabelle wird gleichzeitig ein Wert der Escape-Tabelle zugeordnet, welcher zusammen mit dem maximalen Wert der Grund-Codetabelle den entsprechenden Spektralwert ergibt.

Gemäß einer weiteren Ausgestaltung des zweiten Aspekts der vorliegenden Erfindung wird der Abstand der Rasterpunkte einer Gruppe (beispielsweise der Gruppe 1 oder der Gruppe 2) nicht mehr gleich der Länge des längsten Codeworts einer Codetabelle eingestellt, sondern gleich der Länge des längsten tatsächlich auftretenden Codeworts in einem Bitstrom, der zu einer Codetabelle gehört. Dies stellt eine weitere Verbesserung gegenüber der ersten Ausgestaltung des zweiten Aspekts der vorliegenden Erfindung dar, da auch trotz dieses Verfahrens die Codiereffizienz bei der Escape-Tabelle immer noch nicht optimal ist. Aus codiertechnischen Gründen ist die Maximallänge des Codes dieser Tabelle (innerhalb eines Spektrums) meist wesentlich geringer. Das längste Codewort in der Escape-Tabelle ist beispielsweise 49 Bit lang.

Das längste bei üblichen Audiosignalen tatsächlich auftretende Codewort der Escape-Tabelle ist typischerweise etwa 20 Bit lang. Es ist daher möglich, die Zahl der Rasterpunkte und damit die zahl der Prioritätscodewörter, die mit den Rasterpunkten ausgerichtet werden können, weiter zu erhöhen, indem zusätzlich die Länge des längsten Codeworts eines Blocks übertragen wird. Die Rasterlänge ergibt sich dann aus dem Minimum aus der tatsächlich auftretenden maximalen Codewortlänge und der theoretisch maximalen Codewortlänge der gerade verwendeten Tabelle. Für die Bestimmung des Minimums ist es möglich, das tatsächlich auftretende Codewort jeder Codetabelle in einem Audioframe oder lediglich das tatsächlich längste Codewort aller Codetabellen in einem Audioframe zu verwenden. Diese Option arbeitet auch für Nicht-Escape-Tabellen, also für "Grund"-Huffman-Tabellen, jedoch bei weitem nicht so effizient wie für die Escape-Tabellen.

Die Übertragung der Maximallänge eines Codeworts in einem Spektralabschnitt oder Block hat einen weiteren günstigen Nebeneffekt. Der Decodierer kann nämlich aufgrund der maximalen tatsächlich aufgetretenen Länge erkennen, ob in einem unter Umständen gestörten Bitstrom ein längeres Codewort vorhanden ist. Lange Codewörter bedeuten üblicherweise eine hohe Energie der Spektralwerte. Wenn durch einen Übertragungsfehler ein sehr langes Codewort zustande kommt, können außerordentlich hörbare Störungen entstehen. Die Übertragung der Maximallänge ermöglicht somit in den meisten Fällen eine Detektion eines solchen Fehlers und somit Gegenmaßnahmen, welche beispielsweise einfach ein Ausblenden dieses zu langen Codeworts sind, oder eine kompliziertere Verschleierungsmaßnahme.

An dieser Stelle sei angemerkt, daß für eine möglichst fehlerrobuste und dennoch effiziente Codierung möglichst viele Rasterpunkte erwünscht sind. Die Anzahl der Rasterpunkte nach oben ist jedoch durch die insgesamte Länge des Bitstroms begrenzt. Diese sollte natürlich durch die Rasterung nicht vergrößert werden, da dann unbenutzte Stellen im Bitstrom vorhanden sein würden, welche der Philosophie der gesamten Datenkompression widersprechen würden. Dennoch sei darauf hingewiesen, daß zugunsten einer hohen Fehlerrobustheit in bestimmten Anwendungsfällen sehr wohl eine Verlängerung des Bitstroms in Kauf genommen werden kann. Andererseits ist es wünschenswert, ein Raster derart anzuordnen, daß möglichst viele Codewörter an Rasterpunkten beginnen. Die vorliegende Erfindung erlaubt somit wirksam im Gegensatz zum Stand der Technik eine Flexibilisierung des Rasterpunktabstandes. Die Flexibilisierung würde im absolut idealen Fall dazu führen, im wesentlichen jedem Codewort einen Rasterpunkt zuzuordnen, was selbstverständlich nur mit erheblichem Aufwand möglich ist. Die Anordnung der Rasterpunkte, d. h. die Bestimmung der Rasterpunktabstände in Abhängigkeit von den Codetabellen für jeden Spektralabschnitt erlaubt jedoch eine sehr effiziente Annäherung an den Optimalzustand, zumal bei weitem nicht alle Codewörter psychoakustisch bedeutsam sind, und zumal auch alle psychoakustisch weniger bedeutsamen Codewörter ebenfalls in den Bitstrom zwischen die rastermäßig angeordneten psychoakustisch bedeutsamen Codewörter sozusagen einsortiert werden sollten, damit keine unbenutzten Stellen im Bitstrom erhalten werden.

Gemäß einem dritten Aspekt der vorliegenden Erfindung wird von der linear mit der Frequenz steigenden Anordnung im Bitstrom weggegangen, und die Codewörter für verschiedene Spektralwerte werden "gescrambelt". Wenn Fig. 1 betrachtet wird, so ist eine gewissermaßen verschachtelte lineare Anordnung der Codewörter mit der Frequenz zu sehen, da die schraffierten Prioritätscodewörter in aufsteigender Frequenzrichtung angeordnet sind, und da die Nicht-Prioritätscodewörter, die nicht schraffiert sind, ebenfalls in aufsteigender Frequenzreihenfolge im Bitstrom einsortiert sind. Würde nun bei dem in Fig. 1 dargestellten Bitstrom ein sog. "Burst"-Fehler auftreten, d. h. eine Störung, die zur Beschädigung mehrerer aufeinanderfolgender Codewörter führt, so würden beispielsweise die Codewörter 6, 7a, 2, 3 und 7b gleichzeitig zerstört werden.

In dem entsprechenden decodierten Audiosignal würde in dem durch die Prioritätscodewörter 2 und 3 dargestellten Spektralband eine spektralmäßig gesehen relativ breite Störung und damit eher deutlicher hörbare Störung auftreten. Das Problem der Burst-Fehler ist aus dem sehr einfachen Beispiel in Fig. 1 nicht besonders deutlich zu sehen. In der Praxis ist jedoch davon auszugehen, daß viel mehr als fünf Rasterpunkte vorhanden sein werden, wobei sich Burst-Fehler oft über mehrere Rasterpunkte hinweg erstrecken, was zu einem Verlust an Daten für ein relativ breites Frequenzband führen kann. Daher werden gemäß dem dritten Aspekt der vorliegenden Erfindung vorzugsweise die Prioritätscodewörter und optional dazu auch die Nicht-Prioritätscodewörter für die Spektralwerte nicht mehr in aufsteigender Frequenzreihenfolge sondern "gemischt" angeordnet, derart, daß dieselben eine zufällige oder pseudozufällige frequenzmäßige Anordnung haben. Bei einer pseudozufälligen Anordnung müssen keine Informationen bezüglich der Verteilung als Seiteninformationen übertragen werden, da diese Verteilung im Decodierer a priori fest eingestellt werden kann. Dies würde dann dazu führen, daß ein Verlust von im Bitstrom benachbarten Codewörtern nicht zu einem Verlust eines vollständigen Frequenzbands führt, sondern nur zu einem sehr kleinen Verlust in mehreren Frequenzbändern. Diese Störung dürfte kaum hörbar sein und könnte auch effizienter verschleiert werden als ein Verlust eines gesamten Frequenzbands.

Gemäß einem vierten Aspekt der vorliegenden Erfindung ist statt einer linear mit der Frequenz ansteigenden Anordnung der Prioritätscodewörter bzw. der Nicht-Prioritätscodewörter eine Anordnung möglich, die nur z. B. jedes n-te Codewort im Raster anordnet und die restlichen Codewörter dazwischen einsortiert. Wie es bereits erwähnt wurde, ist die Anzahl der Rasterpunkte für einen Bitstrom durch die insgesamte Länge und den gewählten Rasterpunktabstand begrenzt. Wenn beispielsweise an eine Abtastung mit niedriger Bandbreite gedacht wird, so kann der Fall auftreten, daß von den Codewörtern die allermeisten psychoakustisch bedeutsame Codewörter sind, da das gesamte Signal eine theoretisch mögliche Nutzbandbreite von 8 kHz hat, wenn eine Abtastrate von 16 kHz verwendet wird. Erfahrungsgemäß können nur 30% der Codewörter an Rasterpunkten angeordnet werden, wobei die restlichen 70% verwendet werden müssen, um das Raster vollends aufzufüllen. Dies würde jedoch bedeuten, daß nicht der gesamte richtige Frequenzbereich bei Sprachsignalen beispielsweise der Bereich von 0 - 4 kHz mit Prioritätscodewörtern, die an Rasterpunkten angeordnet sind, abgedeckt bzw. "geschützt" werden kann. Um dennoch für den wichtigen Frequenzbereich einen ausreichenden Schutz vor Fehlerfortpflanzungen zu erreichen, wird daher nicht mehr jedes Prioritätscodewort sondern lediglich jedes 2., 3. oder 4. usw. mit einem Rasterpunkt ausgerichtet, während die dazwischenliegenden Prioritätscodewörter nicht mit Rasterpunkten ausgerichtet werden, sondern das Raster auffüllen. Wenn beispielsweise im niedrigen Frequenzbereich jeder 2. Spektralwert bzw. jeder 3. usw. bekannt ist, so können die dazwischenliegenden Codewörter, wenn sie bei einer Übertragung beschädigt werden, im Decodierer unter Umständen durch Fehlerverschleierungstechniken, wie z. B. eine Prädiktion o. ä., wiederhergestellt werden.

Die Verfahren bzw. Vorrichtungen zum Decodieren eines Bitstroms arbeiten im wesentlichen spiegelbildlich zu der beschriebenen Codierung.

Bei einem allgemeinen Verfahren zum Decodieren eines Bitstroms, der ein codiertes Audiosignal darstellt, wobei der codierte Bitstrom Codewörter mit unterschiedlicher Länge aus einer Codetabelle und ein Raster mit äquidistanten Rasterpunkten (10, 12, 14) aufweist, wobei die Codewörter Prioritätscodewörter aufweisen, die bestimmte Spektralwerte darstellen, die im Vergleich zu anderen Spektralwerten psychoakustisch bedeutsam sind, und wobei Prioritätscodewörter mit Rasterpunkten ausgerichtet sind, wird (a) der Abstand D1 zwischen zwei benachbarten Rasterpunkten erfaßt. Wenn der Abstand zwischen zwei Rasterpunkten bekannt ist, können (b) die mit den Rasterpunkten ausgerichteten Prioritätscodewörter in dem codierten Bitstrom umsortiert werden, derart, daß eine frequenzmäßig lineare Anordnung derselben erhalten wird, wobei der Beginn eines Prioritätscodeworts mit einem Rasterpunkt zusammenfällt. Nun liegen die Prioritätscodewörter wieder in der in Fig. 2 gezeigten allgemein frequenzlinearen Anordnung vor, womit (c) die Prioritätscodewörter mit einer Codetabelle, der dieselben angehören, wieder decodiert werden können, um decodierte Spektralwerte zu erhalten. Nach einer (d) Rücktransformation der decodierten Spektralwerte in den Zeitbereich liegt ein decodiertes Audiosignal vor, das auf bekannte Art und Weise verarbeitet werden kann, um beispielsweise einem Lautsprecher zugeführt zu werden.

Ist der Bitstrom mit nur einer einzigen Codetabelle codiert, so kann der Abstand der Rasterpunkte einfach erfaßt werden, indem den Seiteninformationen des Bitstroms entnommen wird, mit welcher Codetabelle codiert wurde. Je nach beschriebener Codierung ist der Abstand dann beispielsweise die Länge des längsten Codeworts dieser Tabelle, die im Codierer fest eingestellt sein könnte. Ist der Abstand die Länge des tatsächlich auftretenden längsten Codeworts in einem Teil des Bitstroms, dem eine Codetabelle zugeordnet ist, so wird derselbe mittels der Seiteninformationen, die dem Bitstrom zugeordnet sind, dem Decodierer mitgeteilt, usw.

Der Decodierer führt eine Umsortierung der Prioritätscodewörter und auch der Nicht-Prioritätscodewörter durch, indem er z. B. einen Zeiger auf den codierten Bitstrom anwendet. Ist dem Decodierer der Rasterabstand bekannt, so kann derselbe bei frequenzmäßig linearer Anordnung der Prioritätscodewörter zu einem Rasterpunkt springen und das dort beginnende Codewort einlesen. Ist das Einlesen eines Codeworts beendet, so springt der Zeiger zu dem nächsten Rasterpunkt und wiederholt den beschriebenen Vorgang. Sind alle Prioritätscodewörter eingelesen, so befinden sich im Bitstrom noch die Nicht-Prioritätscodewörter. Wurde eine jeweils lineare Anordnung der Prioritätscodewörter bzw. der Nicht-Prioritätscodewörter im Bitstrom gewählt, so sind die Nicht-Prioritätscodewörter für sich bereits linear mit der Frequenz angeordnet und können ohne weitere Umsortierung wieder decodiert und rücktransformiert werden.

Wurde einer Codierung nach dem dritten bzw. vierten Aspekt der vorliegenden Erfindung gewählt, so können Scramble-Informationen entweder als Seiteninformationen übertragen werden, oder die Scrambleverteilung ist a priori festgelegt und damit auch dem Decodierer von vorneherein bekannt. Bezüglich des vierten Aspekts gelten dieselben Dinge. Es besteht immer die Möglichkeit, eine Verteilung fest zu vereinbaren oder variabel zu gestalten und dann dem Decodierer über Seiteninformationen mitzuteilen.

Im Nachfolgenden wird auf eine vorteilhafte Bestimmung und Handhabung der Prioritätscodewörter eingegangen. Nach Festlegen eines Rasters für einen codierten Bitstrom, durch Bestimmen des Rasterpunktabstandes bei Verwendung einer einzigen Codetabelle bzw. der Rasterpunktabstände bei Verwendung mehrerer Codetabellen, müssen die Prioritätscodewörter in das Raster positioniert werden, derart, daß der Beginn jedes Prioritätscodeworts mit einem Rasterpunkt zusammenfällt.

Gemäß einem bevorzugten Ausführungsbeispiel der Erfindung wird dieses Positionieren derart durchgeführt, daß Codewörter aus einer Art Sortiertabelle sequentiell in das gewissermaßen leere Raster einsortiert werden. Begonnen wird dabei mit dem ersten Codewort der Sortiertabelle. Durch Einsortieren der Codewörter in die Sortiertabelle kann daher Einfluß auf die Prioritätscodewörter genommen werden, wobei Prioritätscodewörter immer die Codewörter der Sortiertabelle sind, die im Raster Platz haben, d. h. für die Rasterpunkte vorhanden sind. Für Codewörter aus der Sortiertabelle, für die keine Rasterpunkte mehr vorhanden sind, bleibt keine andere Möglichkeit, als dieselben in die noch freien Plätze des Bitstroms einzusetzen. Diese Codewörter aus der Sortiertabelle sind somit keine Prioritätscodewörter im Sinne dieser Erfindung.

Die Anzahl der Prioritätscodewörter wird dabei nicht vorher bestimmt. Es werden solange Prioritätscodewörter geschrieben, bis der zur Verfügung stehende Speicher für den codierten Bitstrom voll ist, d. h. bis kein weiteres Prioritätscodewort mehr geschrieben werden kann. Die Größe des Speichers bestimmt sich aus der Gesamtanzahl der für die spektralen Daten zuvor verwendeten Bits, d. h. durch die Rasterung werden keine zusätzlichen Bits benötigt. Der Speicher ist also durch die Anzahl der Codewörter begrenzt, damit die Codiereffizienz aufgrund der Rastereinordnung nicht abfällt. Selbstverständlich könnten alle Codewörter auf Rasterpunkte plaziert werden, um dieselben fehlerrobust zu machen. Dies würde jedoch zu einer erheblichen Abnahme der Codiereffizienz führen, da die zwischen den Rasterpunkten freibleibenden Bits unbenutzt sind.

Der erste Aspekt der vorliegenden Erfindung bezieht sich auf die Bestimmung der Prioritätscodewörter, d. h. der Codewörter, die Spektralwerte darstellen, die im Vergleich zu anderen Spektralwerten psychoakustisch bedeutsam sind. Eine psychoakustisch bedeutsame Spektrallinie ist beispielsweise eine Spektrallinie, die mehr Energie als eine andere Spektrallinie enthält. Allgemein kann gesagt werden, daß je mehr Energie eine Spektrallinie enthält, umso wichtiger dieselbe ist. Daher ist es einerseits wichtig, daß Spektrallinien mit hoher Energie nicht gestört sind, andererseits ist es genau so wichtig, daß Spektrallinien mit hoher Energie aufgrund von Fehlern nicht entstehen.

Bisher wurde davon ausgegangen, daß sich die Spektrallinien mit hoher Energie vorzugsweise im unteren Teil des Spektrums befinden. Dies stimmt in vielen Fällen, in manchen aber auch nicht. Die vorliegende Erfindung übergeht diese Annahme, indem sie einen implizit vorhandenen Indikator benutzt, um die Energie der in einem Codewort codierten Spektrallinie bzw. Spektrallinien, wenn mehrere Spektrallinien in einem Codewort codiert sind, abzuschätzen.

Dieser Indikator ist das verwendete Codebuch bzw. die verwendete Codetabelle, welche beispielsweise eine Huffman-Code-Tabelle sein kann. Im AAC-Standard werden beispielsweise elf Tabellen verwendet. Die Wertebereiche dieser Tabellen unterscheiden sich wesentlich. Die maximalen Absolutwerte der Tabellen 1 bis 11 stellen sich folgendermaßen dar:
1; 1; 2; 2; 4; 4; 7; 7; 12; 12; 8191.

Aufgrund dieser unterschiedlichen Wertebereiche ist dort der maximale Fehler tabellenabhängig. Er beträgt unter Berücksichtigung des Vorzeichens für jede Tabelle, das entweder in der Tabelle explizit vorhanden ist oder außerhalb der Tabelle mit übertragen wird, das zweifache des genannten Absolutwerts. Erfindungsgemäß wird die Bestimmung der Prioritätscodewörter anhand der verwendeten Codetabelle durchgeführt, wobei der Indikator der höhchste Absolutwert und implizit die Codetabellennummer ist. Als erstes werden Codewörter berücksichtigt, deren Codetabelle den größten Wertebereich hat. Dann folgen Codewörter, deren Codetabelle den zweitgrößten Wert hat, usw. Beim Beispiel des AAC-Standards wird somit als erstes die Tabelle 11 berücksichtigt, gefolgt von Tabelle 9 und 10, bis schließlich die Tabelle 1 und 2 mit der geringsten Priorität folgt. Prioritätscodewörter, die an Rasterpunkten plaziert werden, sind somit die Codewörter in der Sortiertabelle, für die Rasterpunkte vorhanden sind.

Vorteilhaft bei dieser Bestimmung der Codewörter ist die Tatsache, daß keine zusätzlichen Informationen für den Decodierer übertragen werden müssen, da die verwendeten Tabellen bereits in den Seiteninformationen übertragen werden und der Decodierer aus diesen Informationen die während der Übertragung verwendete Codewortreihenfolge bestimmen kann.

Der zweite Aspekt der vorliegenden Erfindung bezieht sich auf die Verwendung von kurzen Abtastfenstern oder "Short Windows" im Gegensatz zu langen Fenstern zur Transformation von zeitdiskreten Abtastwerten des Audiosignals in den Frequenzbereich, um Spektralwerte zu erhalten, die das _{A}udiosignal darstellen. Im AAC-Standard sind ebenso wie im Standard Layer 3 auch kurze Abtastfenster ("Short Windows") definiert. Im Falle kurzer Fenster werden statt einer langen MDCT mehrere kurze MDCTs verwendet.

Beim AAC-Standard wird beispielsweise statt einer MDCT mit 1024 Ausgangswerten eine Gruppe von acht MDCTs mit jeweils 128 Ausgangswerten verwendet. Hierdurch wird die zeitliche Auflösung des Codierers zu Lasten der Frequenzauflösung erhöht. Im allgemeinen werden kurze Fenster bei transienten Signalen verwendet. Werden kurze Fenster verwendet, ergeben sich z. B. bei AAC acht zeitlich aufeinanderfolgende komplette Spektren, d. h. acht Sätze von Spektralwerten, wobei jeder Satz von Spektralwerten das gesamte Spektrum umfaßt. Im Gegensatz zu den langen Fenstern ist jedoch der Abstand zwischen den Spektralwerten ebenfalls achtmal so groß. Dies stellt die verringerte Frequenzauflösung dar, der Codierer hat jedoch hierdurch eine höhere Zeitauflösung.

Beim AAC-Standard wird eine Gruppierung ("Grouping") durchgeführt, d. h. es werden aus den acht Spektren Gruppen gebildet. Für jede dieser Gruppen existiert ein Satz von Skalenfaktoren. Im einfachsten Fall enthält jede Gruppe nur ein Fenster. In diesem Fall müssen acht Skalenfaktorensätze übertragen werden. Um eine stärkere Kompression zu ermöglichen, wird im AAC-Standard in der Regel unter Beachtung psychoakustischer Anforderungen eine Zusammenfassung mehrerer Fenster in eine Gruppe durchgeführt. Hierdurch wird die Anzahl der zu übertragenden Skalenfaktoren verringert, um eine bessere Datenkompression zu erreichen. Die Spektraldaten werden gruppenweise sequentiell übertragen, d. h. in einen codierten Bitstrom geschrieben. Innerhalb der Gruppen wird ein sogenanntes skalenfaktorbandweises "Interleaving", d. h. eine skalenfaktorbandweise Verschachtelung durchgeführt.

Dies sei anhand folgenden Beispiels dargestellt. Im Beispiel wurde eine Gruppierung in drei Gruppen durchgeführt. Die erste Gruppe enthält zwei Fenster, die zweite Gruppe enthält drei Fenster und die dritte Gruppe enthält ebenfalls drei Fenster. Jedes Spektrum weißt 12 Skalenfaktorbänder auf. Die Gruppierung stellt sich dann folgendermaßen dar:

| | | |
|---|---|---|
| 1. Gruppe, | 1. Fenster, | 1. Skalenfaktorband |
| 1. Gruppe, | 2. Fenster, | 1. Skalenfaktorband |
| 1. Gruppe, | 1. Fenster, | 2. Skalenfaktorband |
| 1. Gruppe, | 2. Fenster, | 2. Skalenfaktorband |
| ... | | |
| 1. Gruppe, | 2. Fenster, | 12. Skalenfaktorband |
| 2. Gruppe, | 3. Fenster, | 1. Skalenfaktorband |
| 2. Gruppe, | 4. Fenster, | 1. Skalenfaktorband |
| 2. Gruppe, | 5. Fenster, | 1. Skalenfaktorband |
| 2. Gruppe, | 3. Fenster, | 2. Skalenfaktorband |
| ... | | |

Diese Anordnung ist für die Vorsortierung bzw. Einsortierung von Codewörtern aus der Sortiertabelle in das Raster ungünstig, da bei Durchführung einer sequentiellen Einsortierung das gesamte Spektrum der ersten Gruppen geschützt würde, das der letzten hingegen komplett ungeschützt wäre. Daher wird im Fall von kurzen Fenstern eine Vorsortierung gemäß dem zweiten Aspekt der vorliegenden Erfindung durchgeführt. Hierbei wird im Falle des AAC-Standards die Gruppierung sowie die skalenfaktorbandweise Betrachtung aufgehoben. Es wird eine erneute Vorsortierung durchgeführt, und zwar in Einheiten oder "Units" von Spektrallinien.

Bei einem bevorzugten Ausführungsbeispiel der vorliegenden Erfindung erhält jede Unit 4 Spektrallinien. Bei dem AAC-Standard enthält somit jedes Fenster 32 Units, was 128 Spektrallinien entspricht. Die Anordnung der Spektraldaten geschieht folgendermaßen:

| | |
|---|---|
| 1. Fenster, | 1. Unit |
| 2. Fenster, | 1. Unit |
| ... | |
| 8. Fenster, | 1. Unit |
| 1. Fenster, | 2. Unit |
| 2. Fenster, | 2. Unit |
| ... | |
| 8. Fenster, | 2. Unit |
| 1. Fenster, | 3. Unit |
| ... | |

Durch diese Vorsortierung wird sichergestellt, daß die einzelnen Spektralbereiche aller Fenster in Nachbarschaft zueinander liegen, d. h. daß niedrige Spektralwerte entsprechend der Frequenz aus den einzelnen Sätzen von Spektralwerten in den vorderen Bereich der Sortiertabelle vor den Spektralwerten mit hoher Frequenz geschrieben werden. Sind besonders die Spektralwerte im unteren Spektralbereich psychoakustisch bedeutsam, dann kann ausgehend von dieser beschriebenen Vorsortierung in der Sortiertabelle das Einsortieren aus derselben in das Raster erfolgen. Für diese Vorsortierung der Codewörter, d. h. die Bestimmung der Prioritätscodewörter, sind keine zusätzlichen Informationen zu übertragen, da der Decodierer anhand der Seiteninformationen genau weiß, daß in diesem Block oder "Frame" kurze Fenster verwendet wurden, und der Sortieralgorithmus im Codierer, um die "Units" zu erzeugen, immer fest ist und daher fest in den Decodierer einprogrammiert ist.

An dieser Stelle sei darauf hingewiesen, daß das Vorsortieren von Codewörtern in eine Sortiertabelle dem Bestimmen der Prioritätscodewörter entspricht, da diese Tabelle an sich festlegt, ob Codewörter mit sehr großer Wahrscheinlichkeit an Rasterpunkte geschrieben werden können. Die Codewörter, die mit sehr großer Wahrscheinlichkeit an Rasterpunkten positioniert werden können, d. h. die Prioritätscodewörter, sind nämlich die Codewörter am Beginn bzw. im vorderen oder oberen Bereich der Sortiertabelle.

In Abweichung vom bevorzugten Ausführungsbeispiel wird diese Vorsortierung nicht mittels einer Sortiertabelle geschehen, sondern dieselbe kann ebenfalls durch eine Indizierung durchgeführt werden, derart, daß eine Indizierung der einzelnen Codewörter erfolgt, wobei diese Indizierung die Reihenfolge festlegt, in der die indizierten Codewörter in den Bitstrom geschrieben werden.

Aus dem AAC-Standard ist bekannt, daß einige Codetabellen zweidimensional bzw. vierdimensional sind, d. h., daß ein Codewort zwei bzw. vier Spektralwerte codiert. Daher ist es günstig, vier Spektrallinien oder ein Vielfaches hiervon zu einer Unit zu gruppieren, da so Codewörter, die den gleichen Frequenzbereich codieren, unmittelbar aufeinanderfolgend sortiert werden könnnen. Die Anzahl der Spektrallinien aus einer Unit ist daher vorzugsweise durch die verschiedenen Dimensionen der Codetabellen teilbar, d. h. die Anzahl der Linien pro Unit muß ein gemeinsames Vielfaches der Anzahl der Linien pro Codewort und am besten das kleinste gemeinsame Vielfache sein.

Die vorliegende Erfindung wird durch eine Kombination des ersten und des zweiten Aspekts besonders effizient. Wenn im Falle von kurzen Fenstern die erfindungsgemäße Umsortierung in Units ausgeführt worden ist, so kann die Prioritätscodewortbestimmung mittels des Codetabellen-Indikators nachgeschaltet werden, derart, daß das Ergebnis der Unit-Umsortierung noch einmal umsortiert wird, um sicherzustellen, daß die Codewörter aus höheren Codetabellen Prioritätscodewörter werden, die an festen Rasterpunkten positioniert werden, um eine hohe Fehlersicherheit zu erreichen. Diese Kombination ist nicht zwingend notwendig, liefert aber die besten Ergebnisse.

## Patentansprüche

1. Verfahren zum Codieren eines Audiosignals, um einen codierten Bitstrom zu erhalten, wobei der Bitstrom Codewörter umfaßt, die erzeugt werden durch Transformieren eines Blocks von zeitdiskreten Abtastwerten des Audiosignals in den Frequenzbereich, um einen Block von Spektralwerten zu erhalten, die das Audiosignal darstellen; und Codieren der Spektralwerte mit einer Codetabelle, die eine begrenzte Anzahl von Codewörtern unterschiedlicher Länge aufweist, um durch Codewörter codierte Spektralwerte zu erhalten, wobei die Länge eines einem Spektralwert zugeordneten Codeworts im allgemeinen um so kürzer ist, je höher die Auftrittswahrscheinlichkeit des Spektralwerts ist, mit folgenden Schritten:
Festlegen eines Rasters für den codierten Bitstrom, wobei das Raster äquidistante Rasterpunkte (10, 12, 14) aufweist, und wobei der Abstand (D1) der Rasterpunkte von der Codetabelle abhängt;
Bestimmen von Prioritätscodewörtern aus den Codewörtern, wobei die Codewörter zu Prioritätscodewörtern bestimmt werden, die Spektralwerte darstellen, die im Vergleich zu anderen Spektralwerten psychoakustisch bedeutsam sind; und
Positionieren der Prioritätscodewörter im Raster, derart, daß der Beginn eines Prioritätscodeworts, das einen Spektralwert des Blocks von Spektralwerten darstellt, mit einem Rasterpunkt zusammenfällt, und daß der Beginn eines weiteren Prioritätscodeworts, das einen anderen Spektralwert des Blocks von Spektralwerten darstellt, mit einem anderen Rasterpunkt zusammenfällt.

2. Verfahren nach Anspruch 1,
bei dem eine Mehrzahl von Fenstern verwendet wird, wodurch eine Mehrzahl von Sätzen von Spektralwerten entsteht, wobei jeder Satz von Spektralwerten das gesamte Spektrum umfaßt; und
bei dem im Schritt des Bestimmens von Prioritätscodewörtern die Codewörter als Prioritätscodewörter bestimmt werden, die Spektralwerte mit gleicher Frequenz aus den jeweiligen Sätzen codieren.

3. Verfahren nach Anspruch 1 oder 2, bei dem ein Codewort der Codetabelle eine Mehrzahl von Spektralwerten codiert, wobei die Spektralwerte in Gruppen oder Units zusammengefaßt werden, derart, daß die Anzahl der Spektralwerte in einer Gruppe durch die Mehrzahl von Spektralwerten, die ein Codewort codiert, teilbar ist.

4. Verfahren nach Anspruch 3, bei dem verschiedene Codetabellen mit unterschiedlichen Dimensionen, d. h. Spektralwerten pro Codewort, verwendet werden, wobei eine Einheit n Spektralwerte aufweist, wobei n ein gemeinsames Vielfaches aller auftretenden Dimensionen ist.

5. Verfahren nach einem der Ansprüche 1 bis 3, bei dem im Schritt des Bestimmens von Prioritätscodewörtern die Codewörter als Prioritätscodewörter bestimmt werden, die Spektralwerte der Sätze von Spektralwerten codieren, die niedrigen Frequenzen zugeordnet sind.

6. Verfahren nach Anspruch 5, bei dem der Schritt des Bestimmens von Prioritätscodewörtern folgenden Schritt aufweist:
aufeinanderfolgendes Plazieren der Codewörter in eine Sortiertabelle, wobei Prioritätscodewörter Codewörter im vorderen Bereich der Sortiertabelle sind und damit sicherer auf Rasterpunkte positioniert werden, als Codewörter weiter hinten in der Sortiertabelle, derart, daß durch die Reihenfolge der Codewörter in der Sortiertabelle eine Prioritätsverteilung innerhalb der Codewörter auftritt, um Prioritätscodewörter zu erhalten; und
bei dem der Schritt des Positionierens der Prioritätscodewörter folgenden Schritt aufweist:
aufeinanderfolgendes Positionieren der Codewörter aus der Sortiertabelle auf Rasterpunkte, bis keine Rasterpunkte mehr vorhanden sind;
Positionieren der noch verbleibenden Codewörter aus der Sortiertabelle an Stellen zwischen dem Raster, die noch frei sind.

7. Verfahren nach einem der vorhergehenden Ansprüche, bei dem im Schritt des Bestimmens von Prioritätscodewörtern die Codewörter als Prioritätscodewörter bestimmt werden, die Spektralwerte mit niedriger Frequenz und/oder hoher Energie codieren.

8. Verfahren nach einem der vorhergehenden Ansprüche, bei dem der Abstand der Rasterpunkte etwas kleiner, gleich oder größer als das längste Codewort der Codetabelle oder gleich oder größer als das längste tatsächlich auftretende Codewort im Bitstrom ist.

9. Verfahren nach Anspruch 1, bei dem vor dem Codieren der Spektralwerte ein Gruppieren der Spektralwerte in aneinandergrenzende Spektralabschnitte durchgeführt wird, wobei jeder Spektralabschnitt wenigstens einen Spektralwert umfaßt, und ferner ein Zuweisen von zumindest zwei unterschiedlichen Codetabellen aus einer vorgegebenen Anzahl von Codetabellen zu zwei unterschiedlichen Spektralabschnitten durchgeführt wird, wobei einem Spektralabschnitt die Codetabelle zugewiesen wird, die für die Codierung der Spektralwerte in dem Spektralabschnitt am günstigsten ist durchgeführt wird,
wobei beim Codieren die Spektralwerte aus den Spektralabschnitten mit der Codetabelle, die dem entsprechenden Spektralabschnitt zugewiesen ist, codiert werden; und
wobei im Schritt des Festlegens ein Raster für den codierten Bitstrom festgelegt wird, wobei das Raster zumindest zwei Gruppen von Rasterpunkten (10, 12, 14 bzw. 14, 16, 18) aufweist, wobei die Rasterpunkte jeder Gruppe in sich äquidistant angeordnet sind, und wobei der Rasterpunktabstand (D1 bzw. D2) jeder Gruppe von einer entsprechenden der zumindest zwei unterschiedlichen Codetabellen abhängt.

10. Verfahren nach Anspruch 9, bei dem im Schritt des Bestimmens von Prioritätscodewörtern ein Codewort als Prioritätscodewort bestimmt wird, wenn ein Indikator, der von der Codetabelle abhängt, aus der das Codewort stammt, auf eine Priorität hinweist.

11. Verfahren nach Anspruch 10,
bei dem jede Codetabelle einen maximalen Absolutwert für einen zu codierenden Spektralwert aufweist; und
bei dem der Indikator die höchste Priorität anzeigt, wenn die Codetabelle, von der der Indikator abhängt, den höchsten Absolutwert aller Codetabellen aufweist.

12. Verfahren nach einem der Ansprüche 9 bis 11,
bei dem jede Codetabelle einen maximalen Absolutwert für einen zu codierenden Spektralwert aufweist; und
bei dem eine Vielzahl von Codetabellen verwendet wird, wobei ein Indikator für jede Tabelle vorhanden ist, wobei der Indikator durch den höchsten Absolutwert der jeweiligen Tabelle bestimmt ist, und wobei der Indikator für eine Tabelle mit einem größeren maximalen Absolutwert eine höhere Priorität für ein Codewort aus der Tabelle anzeigt, als ein Indikator für eine andere Tabelle mit einem kleineren maximalen Absolutwert.

13. Verfahren nach einem der Ansprüche 9 bis 12, bei dem der Rasterpunktabstand (D1, D2) jeder Gruppe von Rasterpunkten kleiner, gleich oder größer als die Länge des längsten Codeworts der entsprechenden Codetabelle ist.

14. Verfahren nach einem der Ansprüche 9 bis 12, bei dem der Rasterpunktabstand (D1, D2) jeder Gruppe von Rasterpunkten gleich der Länge des längsten, tatsächlich auftretenden Codeworts für einen Spektralwert in dem entsprechenden Spektralabschnitt ist; und
bei dem die Länge des längsten, tatsächlich auftretenden Codeworts eines Spektralabschnitts als Seiteninformationen zum Bitstrom übertragen wird.

15. Verfahren nach einem der Ansprüche 9 bis 12, bei dem der Rasterpunktabstand einer Gruppe von Rasterpunkten derart bestimmt wird, daß derselbe gleich dem Minimum aus dem längsten, tatsächlich auftretenden Codewort aller gruppierten Spektralabschnitte und dem längsten Codewort der Codetabelle dieser Gruppe ist, wobei das längste, tatsächlich auftretende Codewort als Seiteninformationen zu einem Decodierer übertragen wird.

16. Verfahren nach einem der vorhergehenden Ansprüche, bei dem bezüglich der Prioritätscodewörter und der Nicht-Prioritätscodewörter im Raster des Bitstroms jeweils eine frequenzmäßig im wesentlichen lineare Anordnung der Codewörter eingehalten wird.

17. Verfahren nach einem der Ansprüche 1 - 15, bei dem die Codewörter, die codierte Spektralwerte darstellen, im Raster des Bitstroms unabhängig von der Frequenz der entsprechenden Spektralwerte angeordnet werden.

18. Verfahren nach Anspruch 17, bei dem Informationen bezüglich der Zuordnung zwischen der Frequenz und dem Codewort als Seiteninformationen in den Bitstrom eingebracht werden, wenn die von der Frequenz unabhängige Verteilung nicht vorbestimmt ist.

19. Verfahren nach Anspruch 1 oder Anspruch 9, bei dem lediglich jedes n-te Codewort der Prioritätscodewörter im Raster des Bitstroms angeordnet wird, während die restlichen Prioritätscodewörter und Nicht-Prioritätscodewörter nicht an Rasterpunkten ausgerichtet werden.

20. Verfahren nach einem der vorhergehenden Ansprüche, bei dem die Spektralwerte vor dem Codieren unter Berücksichtigung des psychoakustischen Modells quantisiert werden.

21. Vorrichtung zum Codieren eines Audiosignals, um einen codierten Bitstrom zu erhalten, wobei der Bitstrom Codewörter umfaßt, die erzeugt werden durch Transformieren eines Blocks von zeitdiskreten Abtastwerten des Audiosignals in den Frequenzbereich, um einen Block von Spektralwerten zu erhalten die das Audiosignal darstellen und Codieren der Spektralwerte mit einer Codetabelle, die eine begrenzte Anzahl von Codewörtern unterschiedlicher Länge aufweist, um durch Codewörter codierte Spektralwerte zu erhalten, wobei die Länge eines einem Spektralwert zugeordneten Codeworts im allgemeinen um so kürzer ist, je höher die Auftrittswahrscheinlichkeit des Spektralwerts ist, mit folgenden Merkmalen:
einer Einrichtung zum Festlegen eines Rasters für den codierten Bitstrom, wobei das Raster äquidistante Rasterpunkte (10, 12, 14) aufweist, und wobei der Abstand (D1) der Rasterpunkte von der Codetabelle abhängt;
einer Einrichtung zum Bestimmen von Prioritätscodewörtern aus den Codewörtern, wobei die Codewörter zu Prioritätscodewörtern bestimmt werden, die Spektralwerte darstellen, die im Vergleich zu anderen Spektralwerten psychoakustisch bedeutsam sind; und
einer Einrichtung zum Positionieren der Prioritätscodewörter im Raster, derart, daß der Beginn eines Prioritätscodeworts, das einen Spektralwert des Blocks von Spektralwerten darstellt, mit einem Rasterpunkt zusammenfällt, und daß der Beginn eines weiteren Prioritätscodeworts, das einen anderen Spektralwert des Blocks von Spektralwerten darstellt, mit einem anderen Rasterpunkt zusammenfällt.

22. Vorrichtung nach Anspruch 21, bei der vor dem Transformieren ein Gruppieren der Spektralwerte in aneinandergrenzende Spektralabschnitte, wobei jeder Spektralabschnitt wenigstens einen Spektralwert umfaßt, und ein Zuweisen von zumindest zwei unterschiedlichen Codetabellen aus einer vorgegebenen Anzahl von Codetabellen zu zwei unterschiedlichen Spektralabschnitten, wobei einem Spektralabschnitt die Codetabelle zugewiesen wird, die für die Codierung der Spektralwerte in dem Spektralabschnitt am günstigsten ist, durchgeführt wird,
wobei beim Codieren die Spektralwerte aus den Spektralabschnitten mit der Codetabelle codiert werden, die dem entsprechenden Spektralabschnitt zugewiesen ist;
wobei die Einrichtung zum Festlegen ausgebildet ist, um ein Raster für den codierten Bitstrom festzulegen, wobei das Raster zumindest zwei Gruppen von Rasterpunkten (10, 12, 14 bzw. 14, 16, 18) aufweist, wobei die Rasterpunkte jeder Gruppe in sich äquidistant angeordnet sind, und wobei der Rasterpunktabstand (D1 bzw. D2) jeder Gruppe von einer entsprechenden der zumindest zwei unterschiedlichen Codetabellen abhängt.

23. Verfahren zum Decodieren eines Bitstroms, der ein codiertes Audiosignal darstellt, wobei der codierte Bitstrom Codewörter mit unterschiedlicher Länge aus einer Codetabelle und ein Raster mit äquidistanten Rasterpunkten (10, 12, 14) aufweist, wobei die Codewörter Prioritätscodewörter aufweisen, die bestimmte Spektralwerte eines Blocks von Spektralwerten darstellen, die im Vergleich zu anderen Spektralwerten psychoakustisch bedeutsam sind, wobei der Block von Spektralwerten ein Spektrum eines Blocks von zeitlichen Abtastwerten des Audiosignals darstellt, und wobei Prioritätscodewörter mit Rasterpunkten ausgerichtet sind, so daß der Beginn eines Prioritätscodeworts, das einen Spektralwert des Blocks von Spektralwerten darstellt, mit einem Rasterpunkt zusammenfällt, und daß der Beginn eines weiteren Prioritätscodeworts, das einen anderen Spektralwert des Blocks von Spektralwerten darstellt, mit einem anderen Rasterpunkt zusammenfällt, mit folgenden Schritten:
Erfassen des Abstands (D1) zwischen zwei benachbarten Rasterpunkten; und
Auslesen oder im Falle einer frequenzmäßig nicht linearen Anordnung Umsortieren der mit den Rasterpunkten ausgerichteten Prioritätscodewörter in dem codierten Bitstrom, derart, daß eine frequenzmäßig lineare Anordnung derselben erhalten wird, wobei der Beginn eines Prioritätscodeworts mit einem Rasterpunkt zusammenfällt, so daß durch Decodieren der Prioritätscodewörter mit einer Codetabelle, der dieselben angehören, um decodierte Spektralwerte zu erhalten, und durch Rücktransformieren der decodierten Spektralwerte in den Zeitbereich ein decodiertes Audiosignal erhaltbar ist.

24. Verfahren nach Anspruch 23, bei dem der codierte Bitstrom Codewörter mit unterschiedlicher Länge aus zumindest zwei Codetabellen und ein Raster mit zumindest zwei Gruppen von äquidistanten Rasterpunkten (10, 12, 14 bzw. 14, 16, 18) aufweist, das ferner folgenden Schritt aufweist:
Ermitteln der einem Spektralabschnitt zugeordneten Codetabelle; und
wobei beim Decodieren die Prioritätscodewörter eines Spektralabschnitts mit der entsprechenden Codetabelle, der dieselben angehören, decodiert werden.

25. Vorrichtung zum Decodieren eines Bitstroms, der ein codiertes Audiosignal darstellt, wobei der codierte Bitstrom Codewörter mit unterschiedlicher Länge aus einer Codetabelle und ein Raster mit äquidistanten Rasterpunkten (10, 12, 14) aufweist, wobei die Codewörter Prioritätscodewörter aufweisen, die bestimmte Spektralwerte eines Blocks von Spektralwerten darstellen, die im Vergleich zu anderen Spektralwerten psychoakustisch bedeutsam sind, wobei der Block von Spektralwerten ein Spektrum eines Blocks von zeitlichen Abtastwerten des Audiosignals darstellt, und wobei Prioritätscodewörter mit Rasterpunkten ausgerichtet sind, so daß der Beginn eines Prioritätscodeworts, das einen Spektralwert des Blocks von Spektralwerten darstellt, mit einem Rasterpunkt zusammenfällt, und daß der Beginn eines weiteren Prioritätscodeworts, das einen anderen Spektralwert des Blocks von Spektralwerten darstellt, mit einem anderen Rasterpunkt zusammenfällt, mit folgenden Merkmalen:
(a) einer Einrichtung zum Erfassen des Abstands (D1) zwischen zwei benachbarten Rasterpunkten; und
(b) einer Einrichtung zum Auslesen oder im Falle einer frequenzmäßig nicht linearen Anordnung Umsortieren der mit den Rasterpunkten ausgerichteten Prioritätscodewörter in dem codierten Bitstrom, derart, daß eine frequenzmäßig lineare Anordnung derselben erhalten wird, wobei der Beginn eines Prioritätscodeworts mit einem Rasterpunkt zusammenfällt, so daß durch Decodieren der Prioritätscodewörter mit einer Codetabelle, der dieselben angehören, um decodierte Spektralwerte zu erhalten, und Rücktransformieren der decodierten Spektralwerte in den Zeitbereich ein decodiertes Audiosignal erhaltbar ist.

26. Vorrichtung nach Anspruch 25, bei dem der codierte Bitstrom Codewörter mit unterschiedlicher Länge aus zumindest zwei Codetabellen und ein Raster mit zumindest zwei Gruppen von äquidistanten Rasterpunkten (10, 12, 14 bzw. 14, 16, 18) aufweist, die ferner folgendes Merkmal aufweist:
eine Einrichtung zum Ermitteln der, einem Spektralabschnitt zugeordneten Codetabelle;
wobei beim Decodieren die Prioritätscodewörter eines Spektralabschnitts mit der entsprechenden Codetabelle, der dieselben angehören, decodierbar sind.

## Claims

1. A method for coding an audio signal to obtain a coded bit stream, wherein the bit stream includes code words created by transforming a block of discrete-time samples of the audio signal into the frequency domain to obtain a block of spectral values which represent the audio signal; and coding the spectral values with a code table having a limited number of code words of different length to obtain spectral values coded with code words, the length of a code word which is assigned to a spectral value generally being that much shorter the higher the probability of occurrence of the spectral value is, comprising the following steps:
determining a raster for the coded bit stream where the raster has equidistant raster points (10, 12, 14) and where the separation (D1) of the raster points depends on the code table;
defining priority code words among the code words, those code words which represent spectral values which are psychoacoustically important compared to other spectral values being defined as priority code words;
positioning the priority code words in the raster so that the start of a priority code word which represents a spectral value of the block of spectral values coincides with one raster point and the start of another priority code word which represents another spectral value of the block of spectral values coincides with another raster point.

2. A method according to claim 1,
wherein a plurality of windows is used, whereby a plurality of sets of spectral values results, where each set of spectral values comprises the complete spectrum; and
wherein, in the step of defining priority code words, those code words which code spectral values of the same frequency from the respective sets are defined to be priority code words.

3. A method according to claim 1 or 2, wherein a code word of the code table codes a plurality of spectral values, the spectral values being combined into groups or units in such a way that the number of spectral values in a group is divisible by the plurality of spectral values which a code word codes.

4. A method according to claim 3, wherein various code tables with different dimensions, i.e. spectral values per code word, are used, a unit having n spectral values, where n is a common multiple of all the dimensions which occur.

5. A method according to one of the claims 1 to 3,
wherein, in the step of defining priority code words, the code words which code the spectral values of the sets of spectral values which are assigned to low frequencies are defined to be priority code words.

6. A method according to claim 5, wherein the step of defining priority code words includes the following step:
placing the code words in sequence in a sort table, priority code words being code words in the front part of the sort table and therefore more likely to be positioned on raster points than code words further back in the table, in such a way that the sequence of code words in the sort table constitutes a priority distribution within the code words, thus producing priority code words; and
wherein the step of positioning the priority code words includes the following step:
successive positioning of the code words from the sort table on raster points until no raster points are left;
positioning the remaining code words from the sort table at locations in the raster which are still unoccupied.

7. A method according to one of the preceding claims,
wherein, in the step of defining priority code words, the code words which code spectral values with low frequency and/or high energy are defined to be priority code words.

8. A method according to one of the preceding claims,
wherein the distance between the raster points is somewhat smaller than, equal to or greater than the longest code word of the code table or is equal to or greater than the longest code word actually appearing in the bit stream.

9. A method according to claim 1, wherein before coding the spectral values grouping the spectral values into adjacent spectral sections is performed, each spectral section having at least one spectral value, and further assigning at least two different code tables from a predetermined number of code tables to two different spectral sections is performed, a spectral section having assigned to it that code table which is best suited for coding the spectral values in the spectral section,
wherein, in coding, the spectral values from the spectral sections are coded with the code table which is assigned to the corresponding spectral section; and
wherein, in the step of specifying, a raster is specified for the coded bit stream such that the raster has at least two groups of raster points (10, 12, 14 and 14, 16, 18), such that the raster points of each group are spaced equidistantly from one another and such that the raster point distance (D1 or D2) of each group depends on an appropriate code table from among the at least two different code tables.

10. A method according to claim 9, wherein, in the step of defining priority code words, a code word is defined to be a priority code word when an indicator, which depends on the code table from which the code word originates, indicates priority.

11. A method according to claim 10,
wherein each code table has a maximum absolute value for a spectral value which is to be coded; and
wherein the indicator indicates the highest priority when the code table on which the indicator depends has the highest absolute value of all the code tables.

12. A method according to one of the claims 9 to 11,
wherein each code table has a maximum absolute value for a spectral value which is to be coded; and
wherein a plurality of code tables is used, where there is an indicator for each table, where the indicator is determined by the highest absolute value of the respective table and where the indicator for a table with a greater maximum absolute value indicates a higher priority for a code word from the table than does an indicator for another table with a smaller maximum absolute value.

13. A method according to one of the claims 9 to 12,
wherein the raster point distance (D1, D2) of each group of raster points is smaller than, equal to or greater than the length of the longest code word of the corresponding code table.

14. A method according to one of the claims 9 to 12,
wherein the raster point distance (D1, D2) of each group of raster points is equal to the length of the longest actually occurring code word for a spectral value in the corresponding spectral section; and
wherein the length of the longest actually occurring code word of a spectral section is transmitted as side information to the bit stream.

15. A method according to one of the claims 9 to 12,
wherein the raster point distance of a group of raster points is so determined as to be equal to the minimum of the longest actually occurring code word of all the grouped spectral sections and the longest code word of the code table of this group, and where the longest actually occurring code word is transmitted to a decoder as side information.

16. A method according to one of the preceding claims,
wherein a substantially linear arrangement of the code words with frequency is adhered to in the raster of the bit stream both for the priority code words and for the non-priority code words.

17. A method according to one of the claims 1 - 15,
wherein the code words which represent coded spectral values are arranged in the raster of the bit stream independently of the frequency of the corresponding spectral values.

18. A method according to claim 17, wherein information regarding the correspondence between the frequency and the code word is inserted in the bit stream as side information when the frequency independent distribution is not predetermined.

19. A method according to claim 1 or claim 9, wherein only each n-th code word of the priority code words is arranged in the raster of the bit stream while the remaining priority code words and non-priority code words are not aligned with raster points.

20. A method according to one of the preceding claims,
wherein the spectral values are quantized prior to coding taking the psychoacoustic model into account.

21. A device for coding an audio signal to obtain a coded bit stream, wherein the bit stream includes code words created by transforming a block of discrete-time samples of the audio signal into the frequency domain to obtain a block of spectral values which represent the audio signaland coding the spectral values with a code table having a limited number of code words of different lengths to obtain spectral values coded with code words, the length of a code word which is assigned to a spectral value generally being that much shorter the higher the probability of occurrence of the spectral value is,comprising:
a unit for determining a raster for the coded bit stream where the raster has equidistant raster points (10, 12, 14) and where the separation (D1) of the raster points depends on the code table;
a unit for defining priority code words among the code words, those code words which represent spectral values which are psychoacoustically important compared to other spectral values being defined as priority code words; and
a unit for positioning the priority code words in the raster so that the start of a priority code word which represents a spectral value of the block of spectral values coincides with one raster point and the start of another priority code word which represents another spectral value of the block of spectral values coincides with another raster point.

22. A device according to claim 21, wherein beforé transforming grouping the spectral values into adjacent spectral sections, each spectral section having at least one spectral value, and assigning at least two different code tables from a predetermined number of code tables to two different spectral sections, a spectral section having assigned to it that code table which is best suited for coding the spectral values in the spectral section, is performed,
where in coding the spectral values from the spectral sections are coded with the code table which is assigned to the corresponding spectral section;
where the unit for specifying is designed to specify a raster for the coded bit stream such that the raster has at least two groups of raster points (10, 12, 14 and 14, 16, 18), such that the raster points of each group are spaced equidistantly from one another and such that the raster point distance (D1 or D2) of each group depends on an appropriate code table from among the at least two different code tables

23. A method for decoding a bit stream representing a coded audio signal, where the coded bit stream contains code words of different lengths from a code table and has a raster with equidistant raster points (10, 12, 14), where the code words include priority code words, which represent particular spectral values of a block of spectral values which are psychoacoustically important compared to other spectral values,
where the block of spectral values represents a spectrum of a block of temporal samples of the audio signal, and where priority code words are aligned with raster points so that the start of a priority code word representing a spectral value of the block of spectral values coincides with one raster point and the start of another priority code word representing another spectral value of the block of spectral values coincides with another raster point, comprising the following steps:
detecting the distance (D1) between two adjacent raster points; and
reading out or, in the case of a non-linear arrangement with frequency, resorting the priority code words, which are aligned with the raster points, in the coded bit stream in such a way as to obtain a linear arrangement of the same with frequency, the start of a priority code word coinciding with a raster pointso that by decoding the priority code words with an associated code table to obtain decoded spectral values and by transforming the decoded spectral values back into the time domain a decoded audio signal is obtainable.

24. A method according to claim 23, wherein the coded bit stream contains code words of different lengths from at least two code tables and has a raster with at least two groups of equidistant raster points (10, 12, 14 and 14, 16, 18), including the following step:
identifying the code table associated with a spectral section; and
where, in decoding, the priority code words of a spectral section are decoded with the corresponding associated code table.

25. A device for decoding a bit stream representing a coded audio signal, where the coded bit stream contains code words of different lengths from a code table and has a raster with equidistant raster points (10, 12, 14), where the code words include priority code words, which represent particular spectral values of a block of spectral values which are psychoacoustically important compared to other spectral values,
where the block of spectral values represents a spectrum of a block of temporal samples of the audio signal and where priority code words are aligned with raster points so that the start of a priority code word representing the spectral value of the block of spectral values coincides with one raster point and the start of another priority code word representing another spectral value of the block of spectral values coincides with another raster point, comprising:
(a) a unit for detecting the distance (D1) between two adjacent raster points; and
(b) a unit for reading out or, in the case of a non-linear arrangement with frequency, resorting the priority code words, which are aligned with the raster points, in the coded bit stream in such a way as to obtain a linear arrangement of the same with frequency, the start of a priority code word coinciding with a raster point, so that by decoding the priority code words with an associated code table to obtain decoded spectral values, and transforming the decoded spectral values back into the time domain a decoded audio signal is obtainable.

26. A device according to claim 25, wherein the coded bit stream contains code words of different lengths from at least two code tables and has a raster with at least two groups of equidistant raster points (10, 12, 14 and 14, 16, 18), also comprising:
a unit for identifying the code table associated with a spectral section;
where in decoding the priority code words of a spectral section are decodable with the corresponding associated code table.

## Revendications

1. Procédé de codage d'un signal audio, pour obtenir un train binaire codé, le train binaire comportant des mots de code qui sont générés par transformation d'un bloc de valeurs de balayage discrètes dans le temps du signal audio au domaine de la fréquence, pour obtenir un bloc des valeurs spectrales qui représentent le signal audio ; et codage des valeurs spectrales avec un tableau de codes présentant un nombre limité de mots de code de longueur différente, pour obtenir des valeurs spectrales codées par des mots de code, la longueur d'un mot de code associé à une valeur spectrale étant généralement d'autant plus courte que la probabilité de présentation de la valeur spectrale est grande, aux étapes suivantes consistant à :
fixer une trame pour le train binaire codé, la trame présentant des points de trame équidistants (10, 12, 14) et la distance (D1) des points de trame dépendant du tableau de codes ;
déterminer des mots de code prioritaires à partir des mots de code, comme mots de code prioritaires étant déterminés les mots de code qui représentent les valeurs spectrales, qui, par rapport à d'autres valeurs spectrales, sont importantes du point de vue psycho-acoustique; et
positionner les mots de code prioritaires dans la trame, de sorte que le début d'un mot de code prioritaire représentant une valeur spectrale du bloc de valeurs spectrales coïncide avec un point de trame et que le début d'un autre mot de code prioritaire représentant une autre valeur spectrale du bloc de valeurs spectrales coïncide avec un autre point de trame.

2. Procédé selon la revendication 1,
dans lequel sont utilisées une pluralité de fenêtres, d'où sont créés un pluralité d'ensembles de valeurs spectrales, chaque ensemble de valeurs spectrales comportant le spectre complet ; et
dans lequel, à l'étape de détermination de mots de codes prioritaires sont déterminés comme mots de code prioritaires les mots de code codant les valeurs spectrales de même fréquence des ensembles respectifs.

3. Procédé selon la revendication 1 ou 2, dans lequel un mot de code du tableau de codes code une pluralité de valeurs spectrales, les valeurs spectrales étant regroupées en groupes ou unités, de sorte que le nombre de valeurs spectrales dans un groupe soit divisible par la pluralité de valeurs spectrales codant un mot de code.

4. Procédé selon la revendication 3, dans lequel sont utilisés différents tableaux de codes de dimensions différentes, c'est-à-dire de valeurs spectrales par mot de code, une unité présentant n valeurs spectrales, n étant un multiple commun de toutes les dimensions qui se présentent.

5. Procédé selon l'une des revendications 1 à 3, dans lequel sont, à l'étape de détermination, déterminés comme mots de code prioritaires, les mots de code qui codent des valeurs spectrales des ensembles de valeurs spectrales associées à de basses fréquences.

6. Procédé selon la revendication 5, dans lequel l'étape de détermination de mots de code prioritaires présente l'étape suivante consistant à :
placer successivement les mots de code dans un tableau de tri, les mots de code prioritaires étant des mots de code dans la zone avant du tableau de tri et, de ce fait, sûrement positionnés à des points de trame, ainsi que mots de code plus en arrière dans le tableau, de sorte que par l'ordre des mots de code dans le tableau de tri se présente une répartition de priorité dans les mots de code, pour obtenir des mots de code prioritaires ; et
dans lequel l'étape de positionnement des mots de code prioritaires présente l'étape suivante consistant à :
positionner successivement les mots du tableau de codes à des points de trame, jusqu'à ce qu'il n'y ait plus de points de trame ;
positionner les mots de code encore restants du table de tri à des emplacements entre la trame qui sont encore libres.

7. Procédé selon l'une des revendications précédentes, dans lequel sont déterminés comme mots de code prioritaires, à l'étape de détermination de mots de code prioritaires, les mots de code qui codent les valeurs spectrales à basse fréquence et/ou à grande énergie.

8. Procédé selon l'une des revendications précédentes, dans lequel la distance des points de trame est quelque peu inférieure, égale ou supérieure au mot de code le plus long du tableau de codes ou égale ou supérieure au mot de code le plus long se présentant effectivement dans le train binaire.

9. Procédé selon la revendication 1, dans lequel est réalisé, avant le codage des valeurs spectrales, un regroupement des valeurs spectrales en des segments spectraux adjacents, chaque segment spectral comportant au moins une valeur spectrale, et est, par ailleurs, effectuée une attribution d'au moins deux tableaux de codes différents parmi un nombre prédéterminé de tableaux de codes à deux segments spectraux différents, à un segment spectral étant attribué le tableau de codes qui est le plus favorable pour le codage des valeurs spectrales dans le segment spectral ;
lors du codage, les valeurs spectrales des segments spectraux étant codées avec le tableau de codes qui est attribué au segment spectral correspondant ; et
à l'étape d'établissement étant fixée une trame pour le train binaire codé, la trame présentant au moins deux groupes de points de trame (10, 12, 14 ou 14, 16, 18), les points de trame de chaque groupe étant disposés équidistants en soi, et la distance des points de trame (D1 ou D2) de chaque groupe dépendant de l'un correspondant des au moins deux tableaux de codes différents.

10. Procédé selon la revendication 9, dans lequel, à l'étape de détermination de mots de code prioritaires, un mot de code est déterminé comme mot de code prioritaire lorsqu'un indicateur qui dépend du tableau de codes duquel provient le mot de code indique une priorité.

11. Procédé selon la revendication 10,
dans lequel chaque tableau de codes présente une valeur absolue maximale pour une valeur spectrale à coder ; et
dans lequel l'indicateur indique la priorité la plus grande quand le tableau de codes duquel dépend l'indicateur présente la valeur absolue la plus grande de tous les tableaux de codes.

12. Procédé selon l'une des revendications 9 à 11,
dans lequel chaque tableau de codes présente une valeur absolue maximale pour une valeur spectrale à coder ; et
dans lequel il est utilisé une pluralité de tableaux de codes, un indicateur étant présent pour chaque tableau, l'indicateur étant déterminé par la valeur absolue la plus grande du tableau respectif, et l'indicateur pour un tableau à valeur absolue maximale supérieure indiquant une plus grande priorité pour un mot de code du tableau qu'un indicateur pour un autre tableau à valeur absolue maximale inférieure.

13. Procédé selon l'une des revendications 9 à 12, dans lequel la distance des point de trame (D1, D2) de chaque groupe de points de trame est inférieure, égale ou supérieure à la longueur du mot de code le plus long du tableau de codes correspondant.

14. Procédé selon l'une des revendications 9 à 12, dans lequel la distance des points de trame (D1, D2) de chaque groupe de points de trame est égale à la longueur du mot de code le plus long se présentant effectivement pour une valeur spectrale dans le segment spectral correspondant ; et
dans lequel la longueur du mot de code le plus long d'un segment spectral se présentant effectivement est transmise au train binaire comme informations latérales.

15. Procédé selon l'une des revendications 9 à 12, dans lequel la distance des points de trame d'un groupe de points de trame est déterminée de sorte qu'elle soit égale au minimum parmi le mot de code le plus long se présentant effectivement de tous les segments spectraux regroupés et le mot de code le plus long du tableau de codes de ce groupe, le mot de code le plus long se présentant effectivement étant transmis comme informations latérales à un décodeur.

16. Procédé selon l'une des revendications précédentes, dans lequel il est chaque fois maintenu, en ce qui concerne les mots de code prioritaires et les mots de code non prioritaires dans la trame du train binaire, une disposition des mots de code sensiblement linéaire en fréquence.

17. Procédé selon l'une des revendications 1 à 15, dans lequel les mots de code qui représentent des valeurs spectrales codées sont disposés dans la trame du train binaire indépendamment de la fréquence des valeurs spectrales correspondantes.

18. Procédé selon la revendication 17, dans lequel des informations relatives à l'association entre la fréquence et le mot de code sont insérées comme informations latérales dans le train binaire lorsque la répartition indépendante de la fréquence n'est pas prédéterminée.

19. Procédé selon la revendication 1 ou la revendication 9, dans lequel seul chaque n-ième mot de code parmi les mots de code prioritaires est disposé dans la trame du train binaire, tandis que les mots de code prioritaires et les mots de code non prioritaires restants ne sont pas alignés à des points de trame.

20. Procédé selon l'une des revendications précédentes, dans lequel les valeurs spectrales sont quantifiées, avant le codage, en tenant compte du modèle psycho-acoustique.

21. Dispositif de codage d'un signal audio, pour obtenir un train binaire codé, le train binaire comportant des mots de code qui sont générés par transformation d'un bloc de valeurs de balayage discrètes dans le temps du signal audio au domaine de la fréquence, pour obtenir un bloc des valeurs spectrales qui représentent le signal audio et par codage des valeurs spectrales avec un tableau de codes présentant un nombre limité de mots de code de longueur différente, pour obtenir des valeurs spectrales codées par des mots de code, la longueur d'un mot de code associé à une valeur spectrale étant généralement d'autant plus courte que la probabilité de présentation de la valeur spectrale est grande, aux caractéristiques suivantes :
un dispositif destiné à fixer une trame pour le train binaire codé, la trame présentant des points de trame équidistants (10, 12, 14) et la distance (D1) des points de trame dépendant du tableau de codes ; et
un dispositif destiné à déterminer des mots de code prioritaires à partir des mots de code, comme mots de code prioritaires étant déterminés les mots de code qui représentent les valeurs spectrales, qui, par rapport à d'autres valeurs spectrales, sont importantes du point de vue psycho-acoustique ; et ,
un dispositif destiné à positionner les mots de code prioritaires dans la trame, de sorte que le début d'un mot de code prioritaire représentant une valeur spectrale du bloc de valeurs spectrales coïncide avec un point de trame et que le début d'un autre mot de code prioritaire représentant une autre valeur spectrale du bloc de valeurs spectrales coïncide avec un autre point de trame.

22. Dispositif selon la revendication 21, dans lequel sont réalisés, avant la transformation, un regroupement des valeurs spectrales en des segments spectraux adjacents, chaque segment spectral comportant au moins une valeur spectrale, et une attribution d'au moins deux tableaux de codes différents parmi un nombre prédéterminé de tableaux de codes à deux segments spectraux différents, à un segment spectral étant attribué le tableau de codes qui est le plus favorable pour le codage des valeurs spectrales dans le segment spectral,
lors du codage étant codés les valeurs spectrales des segments spectraux avec le tableau de codes qui est attribué au segment spectral correspondant ;
le dispositif de fixation étant réalisé pour fixer une trame pour le train binaire codé, la trame présentant au moins deux groupes de points de trame (10, 12, 14 ou 14, 16, 18), les points de trame de chaque groupe étant disposés équidistants en soi, et la distance des points de trame (D1 ou D2) de chaque groupe dépendant de l'un correspondant des au moins deux tableaux de codes différents.

23. Procédé de décodage d'un train binaire représentant un signal audio codé, le train binaire codé présentant des mots de code de longueur différente d'un tableau de codes et une trame à points de trame équidistants (10, 12, 14), les mots de code présentant des mots de code prioritaires représentant des valeurs spectrales déterminées d'un bloc de valeurs spectrales qui, par rapport à d'autres valeurs spectrales, sont importantes du point de vue psycho-acoustique, le bloc de valeurs spectrales représentant un spectre d'un bloc de valeurs de balayage dans le temps du signal audio, et les mots de code prioritaires étant alignés sur des points de trame, de sorte que le début d'un mot de code de priorité représentant une valeur spectrale du bloc de valeurs spectrales coïncide avec un point de trame, et que le début d'un autre mot de code prioritaire représentant une autre valeur spectrale du bloc de valeurs spectrales coïncide avec un autre point de trame, aux étapes suivantes consistant à :
détecter la distance (D1) entre deux points de trame adjacents; et
lire ou, dans le cas d'un aménagement non linéaire en fréquence, retrier les mots de code prioritaires alignés sur les points de trame dans le train binaire codé, de sorte qu'il soit obtenu une disposition linéaire en fréquence de ceux-ci, le début d'un mot de code prioritaire coïncidant avec un point de trame, de sorte que par décodage des mots de code prioritaires avec un tableau de codes auquel ils appartiennent, pour obtenir des valeurs spectrales décodées, et par retransformation des valeurs spectrales décodées au domaine de temps peut être obtenu un signal audio décodé.

24. Procédé selon la revendication 23, dans lequel le train binaire codé présente des mots de code de longueur différente d'au moins deux tableaux de codes et une trame avec au moins deux groupes de points de trame équidistants (10, 12, 14 ou 14, 16, 18), présentant, par ailleurs, l'étape suivante consistant à :
déterminer le tableau de codes associé à un segment spectral ; et
lors du décodage, les mots de code prioritaires d'un segment spectral étant décodés avec le tableau de codes correspondant auquel ils appartiennent.

25. Dispositif de décodage d'un train binaire représentant un signal audio codé, le train binaire codé présentant des mots de code de longueur différente d'un tableau de codes et une trame à points de trame équidistants (10, 12, 14), les mots de code présentant des mots de code prioritaires représentant des valeurs spectrales déterminées d'un bloc de valeurs spectrales qui, par rapport à d'autres valeurs spectrales, sont importantes du point de vue psycho-acoustique, le bloc de valeurs spectrales représentant un spectre d'un bloc de valeurs de balayage dans le temps du signal audio, et les mots de code prioritaires étant alignés sur des points de trame, de sorte que le début d'un mot de code de priorité représentant une valeur spectrale du bloc de valeurs spectrales coïncide avec un point de trame, et que le début d'un autre mot de code prioritaire représentant une autre valeur spectrale du bloc de valeurs spectrales coïncide avec un autre point de trame, aux caractéristiques suivantes :
(a) un dispositif destiné à détecter la distance (D1) entre deux points de trame adjacents ; et
(b) un dispositif destiné à lie ou, dans le cas d'un aménagement non linéaire en fréquence, retrier les mots de code prioritaires alignés sur les points de trame dans le train binaire codé, de sorte qu'il soit obtenu une disposition linéaire en fréquence de ceux-ci, le début d'un mot de code prioritaire coïncidant avec un point de trame, de sorte que par décodage des mots de code prioritaires avec un tableau de codes auquel ils appartiennent, pour obtenir des valeurs spectrales décodées, et retransformeation des valeurs spectrales décodées au domaine de temps peut être obtenu un signal audio décodé.

26. Dispositif selon la revendication 25, dans lequel le train binaire codé présente des mots de code de longueur différente d'au moins deux tableaux de code et une trame avec au moins deux groupes de points de trame équidistants (10, 12, 14 ou 14, 16, 18), présentant, par ailleurs la caractéristique suivante :
un dispositif destiné à déterminer le tableau de codes associé à un segment spectral ;
lors du décodage, les mots de code prioritaires d'un segment spectral pouvant être décodés avec le tableau de codes correspondant auquel ils appartiennent.
